## Europäisches Patentamt

(19) **European Patent Office**

**Office européen des brevets**

(11) Veröffentlichungsnummer: **0 020 379**
**B1**

(12) # EUROPÄISCHE PATENTSCHRIFT

(45) Veröffentlichungstag der Patentschrift:
**25.01.84**

(51) Int. Cl.³: **H 03 H 19/00,** H 04 J 3/20

(21) Anmeldenummer: **79901010.3**

(22) Anmeldetag: **21.08.79**

(86) Internationale Anmeldenummer:
**PCT/EP 79/00064**

(87) Internationale Veröffentlichungsnummer:
**WO 80/00644 (03.04.80** Gazette 80/7)

(54) **Spannungsumkehrschalter.**

(30) Priorität: **15.09.78 DE 2840346**

(43) Veröffentlichungstag der Anmeldung:
**07.01.81 Patentblatt 81/1**

(45) Bekanntmachung des Hinweises auf die Patenterteilung:
**25.01.84 Patentblatt 84/4**

(84) Benannte Vertragsstaaten:
**FR**

(56) Entgegenhaltungen:
Archiv für Elektronik und Übertragungstechnik, vol. 26 no. 7/8, published in July/August 1972 (Stuttgart,DE) H. Weinrichter "Kondensator-Kommutator-Netzwerke", see Page 293 to 305
Archiv der elektrischen Übertragung, vol. 24, no. 12, published in Dezember 1970 (Stuttgart,DE) A. Fettweis "On the theory of periodically reverse-switched capacitor networks", see Page 539 to 544
Electronics Letters, vol. 14, no. 12, publ. on 8 June 1978 (London GB) G.C. TEMES "The derivation of switched-capacitor filters from active-Re prototypes", see Page 361 and 362
Electronics Letters, vol. 14, no. 9, published on 27 April 1978, (London GB) G.C. TEMES "An improves switched-capacitor integrator", see Page 287 and 288
Archiv für Elektronik und Übertragungstechnik, vol. 33,

(73) Patentinhaber: **SIEMENS AKTIENGESELLSCHAFT, Berlin und München Wittelsbacherplatz 2, D-8000 München 2 (DE)**

(72) Erfinder: **FETTWEIS, Alfred, Im Königsbusch 18, D-4630 Bochum (DE)**

(56) Entgegenhaltungen: (Fortsetzung)
no. 1, publ. in January 1979 (Stuttgart,DE) A. Fettweis "Basic principles of switched-capacitor filters using voltage inverter switches", see Page 13 to 19
Archiv für Elektronik und Übertragungstechnik, vol. 33, no. 3, publ. in March 1979 (Stuttgart,DE) A. Fettweis "Switched capacitor filters using voltage inverter switches: further desing principles", see Page 107 to 114

Spannungsumkehrschalter

Die Erfindung betrifft einen Spannungsumkehrschalter, der derart ausgebildet ist, dass die Spannung an den Schalterklemmen nach Betätigung des Schalters dem Betrage nach gleich gross, jedoch entgegengesetzt gerichtet ist zur Spannung vor Betätigung des Schalters, bestehend aus Schaltern und von diesen in mehreren Taktphasen geschalteten Kondensatoren und Verstärkern, insbesondere zur Verwendung in aktiven Filtern für elektrische Schwingungen.

Spannungsumkehrschalter und Schalterfilter der vorgenannten Art sind für sich bereits bekannt geworden. Eine besondere Gattung solcher Schalterfilter sind die sog. Resonanztransferfilter, die beispielsweise in der Zeitschrift «AEÜ» Band 24, (1970), Seiten 506 bis 512 sowie Band 25, (1971), Seiten 295 bis 303 und vor allem in dem Buch «Network and Switching Theory» (herausgegeben von G. Biorci) und dort unter dem Untertitel «Theory of Resonant-Transfer-Circuits» Seiten 382 bis 446, Academic Press, New York 1968, beschrieben sind. Die praktische Realisierung solcher Filter ist jedoch in einem nicht unerheblichen Mass abhängig von der zur Verfügung stehenden Technologie, insbesondere wenn es darauf ankommt, solche Schalter bzw. Filter mit gut reproduzierbaren Eigenschaften in grösserem Umfang fertigungstechnisch herzustellen.

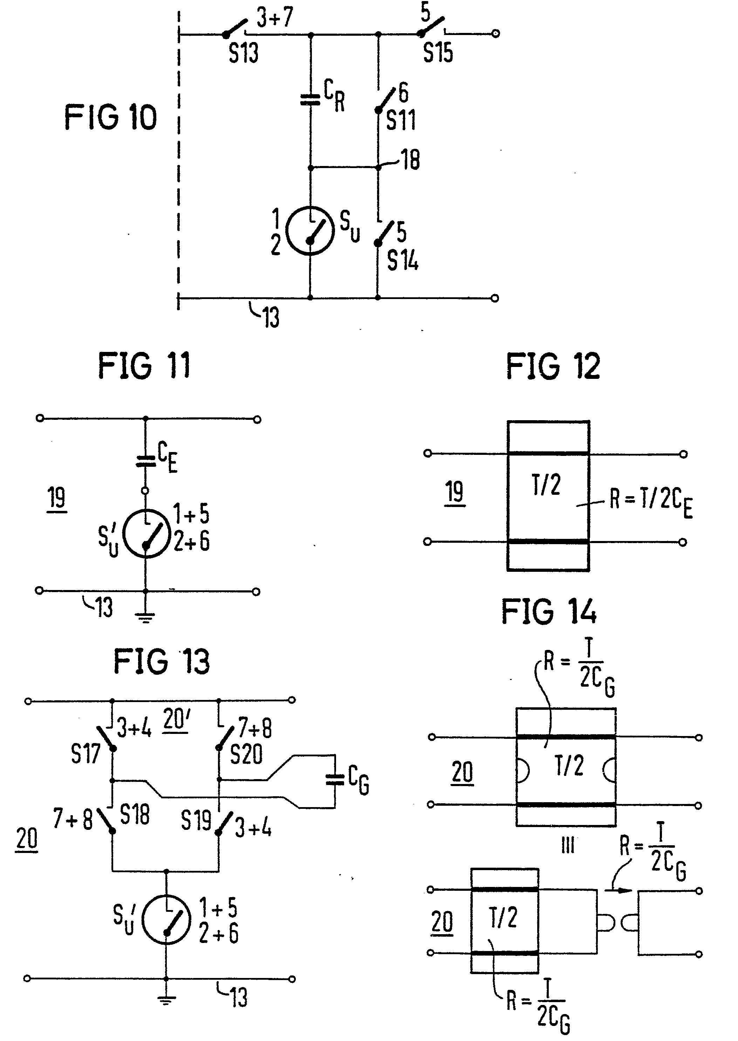

Weiterhin ist in der Druckschrift «AEÜ» Band 26, 1972 Heft 7/8 auf Seite 302 bereits ein elektronischer Kommutator beschrieben, bei dem die Umpolung der Spannung ebenfalls in zwei aufeinanderfolgenden Schritten erfolgt. Im ersten Schritt wird entsprechend der dort gezeigten Fig. 14 ein Hauptschalter geschlossen und bewirkt die vollständige Entladung des umzuladenden Kondensators, während im zweiten Umladeschritt eine als Nachladepumpe bezeichnete Schaltung nochmals die gleiche Ladungsmenge vom Kondensator abzieht und damit für die Umpolung des Kondensators sorgt. Bei dieser bekannten Schaltung wird also eine andere Art der Zwischenspeicherung benutzt.

Der Erfindung liegt die Aufgabe zugrunde, Spannungsumkehrschalter dieser Art anzugeben, bei denen verhältnismässig einfache elektronische Bauelemente verwendet werden können und zugleich die daraus hergestellten Filterschaltungen bereits bei ihrem theoretischen Entwurf keinerlei Einschränkung hinsichtlich des Betriebsverhaltens oder der Lage der Dämpfungspole unterworfen sind.

Erfindungsgemäss wird diese Aufgabe für die einleitend genannten Filter dadurch gelöst, dass die an den Schalterklemmen anliegende Spannung in einer ersten Taktphase über einen ersten Verstärker auf einem Kondensator zwischengespeichert wird und in einer zweiten Taktphase über einen zweiten Verstärker diese Spannung in invertierter Form den Schalterklemmen wieder aufgeprägt wird.

Eine weitere vorteilhafte Lösung ist erfindungsgemäss darin zu sehen, dass in einer ersten Taktphase die Schalterklemmen auf gleiches Potential gebracht werden und die dabei über diese Klemmen fliessende Ladung in einem Kondensator zwischengespeichert wird und dass der Kondensator anschliessend in einer zweiten Taktphase entladen wird und diese Ladung in gleicher Richtung wie in der ersten Taktphase über die Schalterklemmen geführt wird.

Auch in den Unteransprüchen sind vorteilhafte Ausgestaltungen angegeben.

Anhand von Ausführungsbeispielen wird nachstehend die Erfindung noch näher erläutert.

Es zeigen in der Zeichnung:

Fig. 1 eine erste Möglichkeit zur Realisierung eines Spannungsumkehrschalters;

Fig. 2 eine weitere Möglichkeit zur Realisierung eines Spannungsumkehrschalters mit nur einem Verstärkerelement;

Fig. 3 das im folgenden verwendete elektrische Ersatzschaltbild eines Spannungsumkehrschalters in Form eines Schaltsymbols;

Fig. 4 einen möglichen Zeitplan für die erforderlichen Taktphasen für Schaltungen nach den Fig. 1 und 2 und Schaltungen für noch folgende Figuren;

Fig. 5 eine mögliche Realisierungsform für elektronische Schalter, wie sie bei der Erfindung zur Anwendung kommen;

Fig. 6 eine Möglichkeit zur Nachbildung einer Induktivität unter Verwendung eines Kondensators und elektronischer Schalter;

Fig. 7 eine Möglichkeit zur Nachbildung eines ohmschen Widerstandes;

Fig. 8 eine Möglichkeit zur Nachbildung einer Signalquelle mit Innenwiderstand;

Fig. 9 eine Möglichkeit zur Realisierung einer Hochpassschaltung und deren elektrisches Ersatzschaltbild;

Fig. 10 einen Schaltungsabschnitt, mit dessen Hilfe Schaltungen nach Art der Fig. 9 wiederum auf Bezugspotential gelegt werden können;

Fig. 11 eine Schaltungsmöglichkeit zur Nachbildung einer Einheitsleitung (Unit Element);

Fig. 12 das zur Schaltung von Fig. 11 gehörende elektrische Ersatzschaltbild;

Fig. 13 eine Schaltungsmöglichkeit zur Nachbildung einer gyrierenden Einheitsleitung (gyro unit element);

Fig. 14 das zu Fig. 13 gehörende elektrische Ersatzschaltbild;

Fig. 15 eine mögliche Ausgestaltung für eine Bandpassschaltung und das zugehörige elektrische Ersatzschaltbild;

Fig. 16 eine weitere Möglichkeit zur Realisierung eines Spannungsumkehrschalters, für den wiederum das in Fig. 3 gezeichnete elektrische Ersatzschaltbild gilt;

Fig. 17 eine Möglichkeit zur Nachbildung eines Zirkulators;

Fig. 18 das zur Schaltung nach Fig. 17 gehörende elektrische Ersatzschaltbild;

Fig. 19 einen weiteren Taktplan für Schaltungen nach den Fig. 17 und 20;

Fig. 20 eine Allpassschaltung und das zugehörige elektrische Ersatzschaltbild;

Fig. 21 und 23 Kondensator-Schalternetzwerke mit einem dreipoligen Spannungsumkehrschalter.

Filter der einleitend genannten Art sind bekanntlich solche Filter, die nicht Analogsignale im eigentlichen Sinn verarbeiten, sondern solche Signale die in Form von Abtastproben vorliegen, wobei die Abtastproben im Rhythmus einer Taktfrequenz F erzeugt werden und über die Beziehung $T = 1/F$ wird dementsprechend T die Taktperiode genannt. Schaltungen zur Erzeugung solcher Abtastproben sind für sich bekannt, so dass sie an dieser Stelle nicht im einzelnen erläutert werden müssen, es ist jedoch im folgenden davon auszugehen, dass den einzelnen Schaltungen solche Abtastschaltungen jeweils vor- bzw. nachgeschaltet sein können, so dass es also einerseits gelingt, aus einem Analogsignal entnommene Abtastproben den dargestellten Schaltungen zuzuführen und anderseits am Ausgang der Filterschaltung die zur Verfügung stehenden Signale wieder in Analogsignale umzuwandeln. Bei der Erfindung wird von der Erkenntnis ausgegangen, dass ein wesentliches Element solcher Filter sog. Spannungsumkehrschalter sind, bei deren Realisierung von den jetzt zur Verfügung stehenden technologischen Möglichkeiten Gebrauch gemacht wird. Dabei werden nur vergleichsweise wenige kritische elektronische Bausteine wie beispielsweise Operationsverstärker benötigt. Ausserdem zeigt sich, dass hinsichtlich der theoretischen Grundlagen der Filterentwurf in sich abgeschlossen ist und keinerlei Einschränkungen bezüglich der Betriebsrate (Abtastrate) oder der Lage der Dämpfungspole unterliegt und lediglich das Nyquisttheorem zu beachten ist.

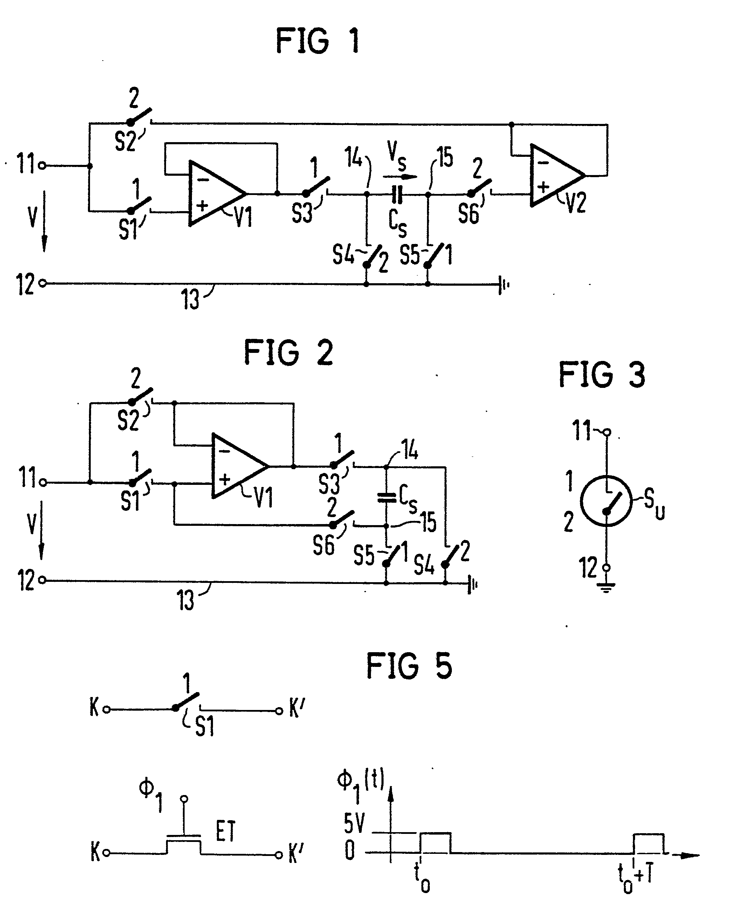

Bei dem in Fig. 1 gezeigten Spannungsumkehrschalter ist es möglich, eine der beiden Schalterklemmen 11 und 12, nämlich die Schalterklemme 12 auf Bezugspotential 13 zu legen, wie dies durch das eingezeichnete Erdsymbol kenntlich gemacht ist. Die Schaltung enthält zwei Operationsverstärker V1 und V2, die deshalb als Verstärker mit dem Verstärkungsfaktor +1 wirken, weil ihr invertierender Eingang – in der Schaltung mit « – » bezeichnet – mit dem Ausgang unmittelbar verbunden ist. In der Schaltung ist weiterhin zu sehen, dass die nichtinvertierenden Eingänge mit « + » bezeichnet sind, wie dies auch für spätere Ausführungen gilt. Die nicht auf Bezugspotential liegende Eingangsklemme 11 ist nun über einen ersten Schalter S1 mit dem nichtinvertierenden Eingang des Verstärkers V1 verbunden. Dem Ausgang des Verstärkers folgt ein Schalter S3 über den ein Schaltungsknoten 14 erreicht wird. Von diesem Knoten führt ein Kondensator $C_s$ zu einem weiteren Schaltungsknoten 15, von dem aus über einen Schalter S6 der nichtinvertierende Eingang des Verstärkers V2 erreicht wird. Im Querzweig der Schaltung sind die Schalter S4 bzw. S5 zu erkennen, die vom Schaltungsknoten 14 bzw. vom Schaltungsknoten 15 nach Bezugspotential 13 führen. In der Schaltung ist nun weiter zu erkennen, dass der Ausgang des zweiten Verstärkers V2 über den Schalter S2 mit der Eingangsklemme 11 verbunden ist.

Die in Fig. 2 gezeichnete Schaltung ermöglicht es, den Spannungsumkehrschalter mit nur einem Verstärkerelement V1 der Verstärker +1 zu realisieren. Es sind wirkungsgleiche Elemente mit den gleichen Bezugsziffern wie in Fig. 1 bezeichnet, so dass ein unmittelbarer Vergleich zwischen den Fig. 1 und 2 möglich ist. Auch in der Schaltung von Fig. 2 führt die Eingangsklemme 11 über den Schalter S1 zum nichtinvertierenden Eingang des Verstärkers V1. Der Ausgang des Verstärkers ist über den Schalter S3 mit dem Schaltungsknoten 14 verbunden, von dem aus der Schaltungsknoten 15 über den Kondensator $C_s$ erreicht wird. Vom Schaltungsknoten 14 führt wiederum der Schalter S4 auf Bezugspotential und vom Schaltungsknoten 15 der Schalter S5 ebenfalls auf Bezugspotential. Abweichend von Fig. 1 wird nun in der Schaltung von Fig. 2 der Schaltungsknoten 15 über den Schalter S6 mit dem nichtinvertierenden Eingang des Verstärkers V1 verbunden; auch ist der Ausgang des Verstärkers V1 über den Schalter S2 mit der Eingangsklemme 11 verbunden. Die zweite Eingangsklemme 12 des Spannungsumkehrschalters liegt wiederum auf Bezugspotential 13. In beiden Schaltungen ist zu erkennen, dass am Kondensator $C_s$ die Spannung $V_s$ auftritt, wenn am Eingang die Spannung V liegt.

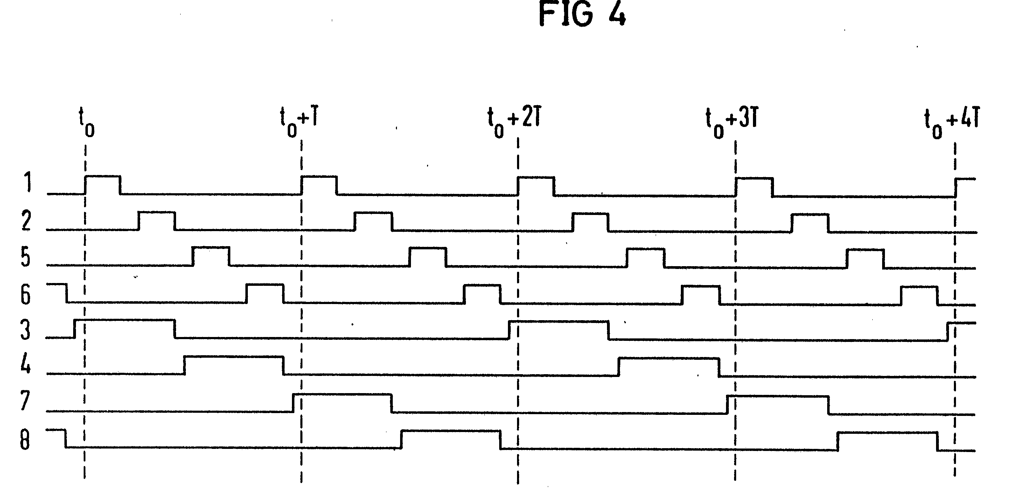

In Fig. 3 ist der in den Fig. 1 und 2 gezeigte Spannungsumkehrschalter $S_u$ symbolisch dargestellt und es sind dementsprechend seine Klemmen mit den Bezugsziffern 11 und 12 bezeichnet. Es sind ferner die Taktphasen 1 und 2 unmittelbar am Spannungsumkehrschalter $S_u$ angegeben, die sich auf die anhand der Fig. 4 noch zu besprechende Lage der Taktphasen bezieht.

In Fig. 4 ist der Zeitplan für acht erforderliche Taktphasen 1 bis 8 gezeichnet, von denen für die Fig. 1 und 2 zunächst nur die Taktphasen 1 und 2 von Bedeutung sind. Vergleicht man zusätzlich die Fig. 1 und 2, so ist zu erkennen, dass die Schalter S1, S3 und S5 über eine erste Taktphase 1 gesteuert sind, während die Schalter S2, S4 und S6 über eine zweite Taktphase 2 gesteuert sind. Diese Taktphasen sind entsprechend dem Taktplan von Fig. 4 unmittelbar an die einzelnen Schalter durch die Bezugshinweise 1 bzw. 2 angeschrieben und es soll auch die symbolische Darstellung von Fig. 3 zusätzlich kenntlich machen, dass der Spannungsumkehrschalter $S_u$ von den Taktphasen 1 und 2 gesteuert wird. Fig. 4 lässt erkennen, dass, ausgehend von einem wählbaren Zeitpunkt $t_o$, die Taktphasen 1 und 2 zeitlich gegeneinander versetzt sind, so dass Schalter mit der Taktphase 1 bereits geöffnet sind, wenn Schalter mit der Taktphase 2 geschlossen werden. In Fig. 4 sind ferner die sich wiederholenden Verhältnisse im Abstand einer Taktperiode T zu erkennen und es sind die zugehörigen Schalter jeweils in den Zeitabschnitten geschlossen, also elektrisch leitend, in denen im Taktplan der horizontale Abschnitt über die Bezugslinie hinausragt. In analoger Weise gilt dies auch, wenn von Fig. 4 abweichende Taktpläne zur Anwendung kommen.

In den Schaltungen nach den Fig. 1 und 2 müssen nicht zwingend Operationsverstärker verwendet werden, wenn nur dafür gesorgt ist, dass Verstärker anderer Art die Verstärkung +1 haben. Allgemein lässt sich sagen, dass die dort gezeigten Schaltungen Ausführungsbeispiele für solche Schaltungen sind, bei denen eine an den Schalterklemmen 11 und 12 anliegende Spannung in einer ersten Taktphase 1 über einen ersten Verstärker V1 auf einem Kondensator $C_s$ zwischengespeichert wird. Anschliessend wird diese Spannung in einer zweiten Taktphase, die zeitlich versetzt ist gegenüber der ersten Taktphase, über einen zweiten Verstärker V2 in invertierter Form den Schalterklemmen 11 und 12 dieses Schalters wieder aufgeprägt. Bevorzugt wird man die Eigenschaften von Operationsverstärkern ausnutzen, wodurch es gemäss Fig. 2 möglich ist, den einzelnen Spannungsumkehrschalter mit nur einem Verstärkerelement zu realisieren.

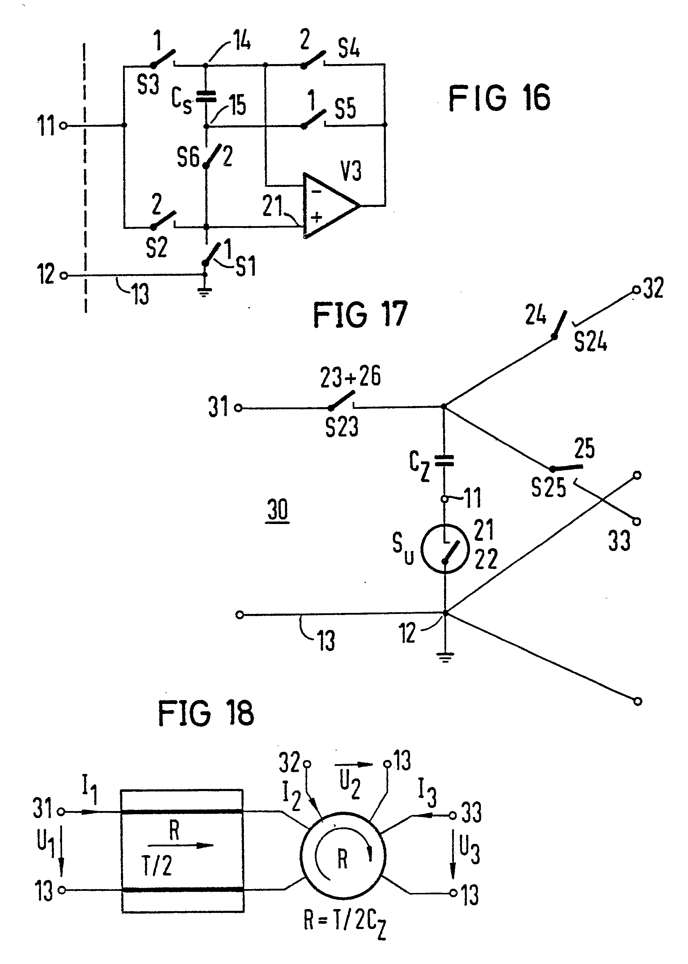

Eine weitere Möglichkeit zur Realisierung eines Spannungsumkehrschalters ist eine Ladungsverdopplung entsprechend dem Prinzip der invertierenden Wiederaufladung. Im einzelnen sei hierzu auf die Fig. 3, 4 und 16 verwiesen. Hierzu werden in einer ersten Taktphase 1 die Schalterklemmen 11 und 12 auf gleiches Potential gebracht und die dabei über diese Klemmen fliessende Ladung in einem Kondensator $C_s$ zwischengespeichert. In der anschliessenden, zeitlich versetzten Taktphase 2, wird der Kondensator entladen und diese Ladung in gleicher Richtung wie in der ersten Taktphase über die Schalterklemmen 11, 12 geführt. Eine mögliche Realisierungsform ist in Fig. 16 unter Verwendung eines Operationsverstärkers V3 gezeichnet. Im übrigen sind in Fig. 16 wirkungsgleiche Elemente mit den gleichen Bezugsziffern wie in den Fig. 1 und 2 bezeichnet und es sind auch an die Schalter wiederum die steuernden Taktphasen 1 und 2 unmittelbar angeschrieben. Wie Fig. 16 weiter erkennen lässt, führt der nichtinvertierende Eingang 21 des Verstärkers V3 über den Schalter S1 auf Bezugspotential 13 und damit zur Anschlussklemme 12 des Schalters. Von der ersten Anschlussklemme 11 wird über den Schalter S2 der nichtinvertierende Eingang 21 des Verstärkers V3 erreicht. Der mit der Bezugsziffer 15 bezeichnete zweite Schaltungsknoten ist über den Schalter S5 mit dem Ausgang des Operationsverstärkers V3 verbunden. Der mit 14 bezeichnete erste Schaltungsknoten ist über den Schalter S4 ebenfalls mit dem Ausgang des Verstärkers V3 verbunden. Auch ist der Schaltungsknoten 14 über den Schalter S3 von der ersten Klemme 11 erreichbar.

Schliesslich ist der Schaltungsknoten 14 auch unmittelbar mit dem invertierenden Eingang des Verstärkers V3 verbunden. Wie in den Schaltungen nach Fig. 1 und 2 werden entsprechend dem Taktschema von Fig. 4 auch in der Schaltung von Fig. 16 die Schalter S1, S3 und S5 von der ersten Taktphase gesteuert, während die Schalter S2, S4 und S6 von der zweiten Taktphase 2 gesteuert werden.

Zur Wirkungsweise lässt Fig. 16 erkennen, dass während der Taktphase 1 die Schalterklemme 11 auf Bezugspotential 13 gebracht wird, da der Operationsverstärker V3 eine gegen Null gehende Differenzeingangsspannung erzwingt. Wegen des extrem hohen Eingangwiderstandes des Operationsverstärkers kann die dabei über die Schalterklemme 11 abfliessende Ladung nur im Kondensator $C_s$ gespeichert werden. Während der Taktphase 2 wird durch die verschwindende Differenzeingangsspannung des Operationsverstärkers V3 die Entladung des Kondensators $C_s$ erzwungen und durch den extrem hohen Eingangswiderstand von V3 dabei sichergestellt, dass die dabei abfliessende Ladung über die Schalterklemme 11 in das die äussere Beschaltung bildende Kondensatornetzwerk geführt wird.

Es lässt sich somit auch für die Schaltung von Fig. 16 das in Fig. 3 gezeichnete Schaltsymbol verwenden, d.h. also, ein Spannungsumkehrschalter mit den Anschlussklemmen 11 und 12, dessen einzelne Schalter von den Taktphasen 1 und 2 gesteuert sind.

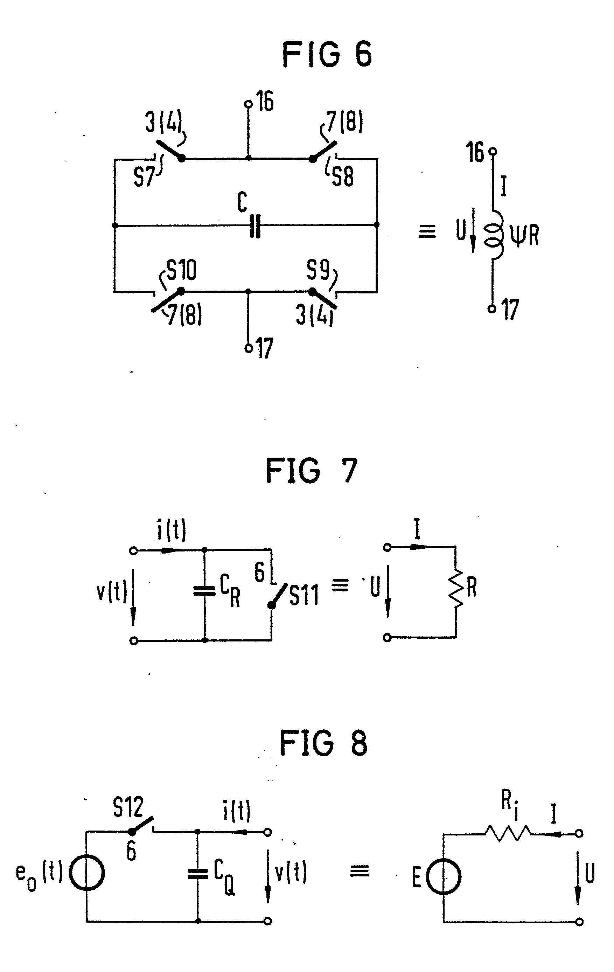

In Fig. 5 ist für den von der Taktphase 1 gesteuerten Schalter S1 mit den Anschlüssen K und K' eine mögliche Realisierungsform einschliesslich des zugehörigen Impulsplanes gezeigt. Es lässt sich hierzu ein sog. Enhancement-MOS-Transistor ET verwenden, der zwischen seinen Anschlüssen K und K' dann elektrisch leitend wird, wenn an seiner Steuerelektrode (Gate) ein Potential $\emptyset_1$ von beispielsweise +5V anliegt. Der Aufbau und die Wirkungsweise solcher MOS-Transistoren ist für sich bekannt, so dass an dieser Stelle nicht im einzelnen darauf eingegangen werden muss. Entsprechend diesem Beispiel lassen sich selbstverständlich auch die übrigen in der Schaltung verwendeten Schalter über geeignete Taktphasen 1 bis 8 steuern.

Bei der Realisierung von Filterschaltungen erscheinen auch Kondensatoren wiederum als Kondensatoren, die lediglich einer abgewandelten theoretischen Betrachtungsweise unterzogen werden. Von der eigentlichen Kondensatorstruktur abweichende Schaltungsstrukturen, beispielsweise Spulen, Signalquellen und dgl. müssen bei der Realisierung solcher Schalterfilter durch geeignete Hilfsmassnahmen nachgebildet werden. Im folgenden seien einige Grundbeispiele angegeben, Beispiele also, die geeignet sind, den Aufbau umfangreicherer Filterstrukturen nach der Theorie der LC-Netzwerke zu ermöglichen.

Fig. 6 zeigt in ihrem elektrischen Ersatzschaltbild eine Induktivität mit den Aschlussklemmen 16 und 17, die vom Strom I durchflossen wird und an der die Spannung U abfällt und deren Impedanz mit $\psi \cdot R$ bezeichnet ist, wobei für $R = T/2C$ gilt. Die in Fig. 6 ebenfalls mitgezeichnete Realisierungsmöglichkeit ist geeignet, den Kondensator C periodisch umzupolen. Es sei hierzu wiederum verwiesen auf den Taktplan von Fig. 4, und es sind entsprechend den bisherigen Ausführungen an die Schalter S7, S8, S9 und S10 unmittelbar die in Fig. 4 gezeichneten Taktphasen anzulegen. Wenn die dabei gezeigten Bedingungen erfüllt sind, dann wirkt der zwischen den Klemmen 16 und 17 geschaltete Zweipol als Induktivität. Aus Fig. 6 ist zu erkennen, dass gewissermassen parallel zum Kondensator C ein Schaltnetzwerk mit den Schaltern S7 und S8 einerseits und S9 und S10 anderseits liegt. Die Anschlussklemmen 16 und 17 sind dabei zwischen die Schalter S7 und S8 bzw. zwischen die Schalter S9 und S10 angeschaltet. Ferner ist zu erkennen, dass die Schalter S7 und S9 von der Taktphase 3 bzw. von der Taktphase 4 gesteuert sind. Die Schalter S8 und S10 sind von der Taktphase 7 bzw. von der Taktphase 8 gesteuert. Die Lage der Taktphasen 3, 4 und 7, 8 braucht zunächst nur relativ zueinander beachtet werden, wenn eine Schaltung nach Fig. 6 lediglich für sich allein betrieben werden soll. Wie aus dem Zeitplan von Fig. 4 zu erkennen ist, sind auch die Taktphasen 3, 4, 7, 8 zueinander so versetzt, dass sich ihre Schaltzeiten nicht überlappen. Wird die Schaltung nach Fig. 6 in einem Filter verwendet, dann ist zusätzlich zu beachten, dass die mit der Taktphase 3 gesteuerten Schalter dann geschlossen sind, wenn zugleich auch die von der Taktphase 1 und 2 gesteuerten Schalter geschlossen sind. Dieser Vorgang wiederholt sich periodisch im Abstand T. Im Zeitpunkt $t_o + T$ sind Schalter, die von der Taktphase 7 gesteuert sind, bereits geschlossen und ihre Schliessungsdauer erstreckt sich wiederum über die Schliessungsdauer der Schalter 1 und 2, was sich ebenfalls periodisch im Abstand T wiederholt. Entsprechend gilt dies für die Taktphasen 4 und 8 mit der bereits erwähnten zeitlichen Verschiebung.

Die Schalter S7 bis S10 sind also nicht Spannungsumkehrschalter im Sinne der Fig. 1, 2 und 16, sondern einfache Schalter, die sich ebenfalls mit der in Fig. 5 gezeigten Transistorschaltung realisieren lassen.

Weitere für den Einsatz in Schalterfiltern geeignete Schaltelemente sind in den Fig. 7 und 8 in Verbindung mit Fig. 4 gezeigt.

Fig. 7 zeigt einen Kondensator $C_R$, der über einen Hilfsschalter S11 zwischen zwei aufeinanderfolgenden Impulsen i(t) kurzgeschlossen wird. Im mitgezeichneten, dazu äquivalenten Ersatzschaltbild ergibt sich ein Widerstand R, an dem die Spannung U anliegt, und der vom Strom I durchflossen wird. Am Schalter S11 ist wiederum die Taktphase 6 angegeben, die gemäss dem Taktplan von Fig. 4 so liegen muss, dass die Schaltung von Fig. 6 bei Verwendung in einer umfangreicheren Filterschaltung so gesteuert sein muss, dass der Schalter S11 nur im Zeitintervall zwischen der Taktphase 2 und der darauffolgenden Taktphase 1 zum Zeitpunkt $t_o + T$ geschlossen ist. Dieser Vorgang wiederholt sich periodisch im Abstand T. Schaltungen nach Fig. 7 lassen sich in umfangreicheren Filterschaltungen beispielsweise als Abschlusswiderstand verwenden.

Die Schaltung nach Fig. 8 eignet sich gemäss ihrem äquivalenten Ersatzschaltbild zur Nachbildung einer Spannungsquelle E mit dem Innenwiderstand $R_i$, die beim Auftreten des Stromes I eine Spannung U am Ausgang abgibt. Es wird dabei eine ideale Signalquelle $e_o(t)$ über einen Schalter S12 an einen Kondensator $C_Q$ geschaltet. Am Ausgang der Schaltung tritt eine Spannung v(t) auf und es fliesst der Strom i(t). Der Schalter S12 wird von der sechsten Taktphase gesteuert, deren Lage relativ zu den übrigen Taktphasen ebenfalls in Fig. 4 dargestellt ist. Auch für die Steuerung des Schalters S12, also für die Taktphase 6 ist von Bedeutung, dass ihre zeitliche Lage so erfolgt, dass der Schalter S12 nur im Zeitintervall zwischen der zweiten und der darauffolgenden ersten Taktphase geschlossen ist, wenn die Schaltung von Fig. 8 eventuell in Verbindung mit bereits beschriebenen Schaltungen in einer umfangreicheren Filterschaltung, die eine LC-Filterschaltung nachbildet, eingesetzt werden soll.

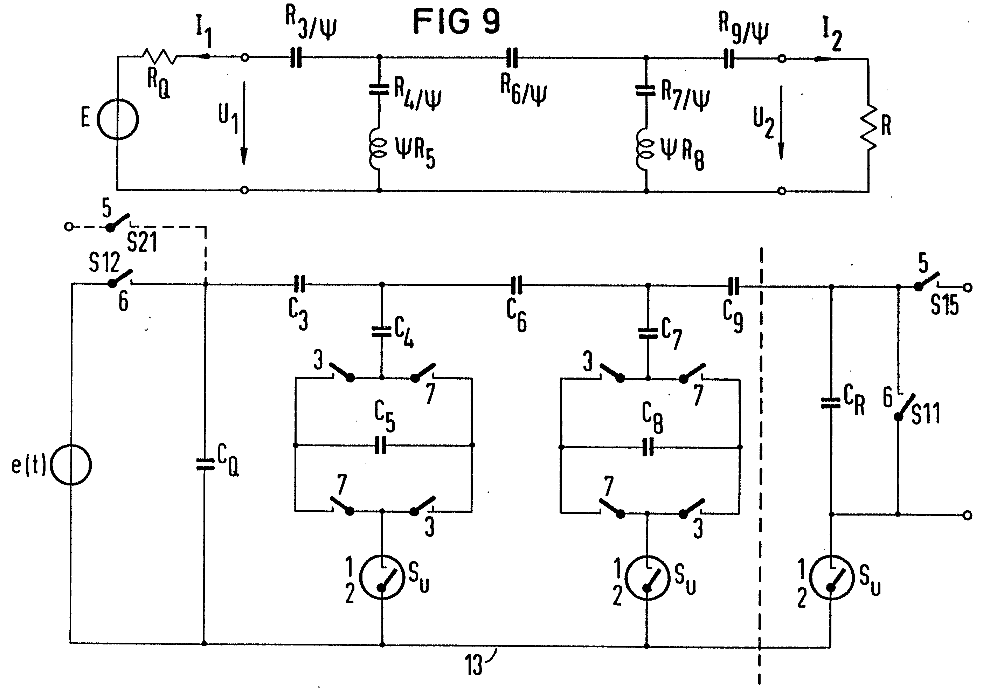

In Fig. 9 ist eine Zusammenschaltung mehrerer einzelner Schaltungsabschnitte zu einem Hochpassfilter fünften Grades gezeigt. Fig. 9a zeigt die zu Fig. 9b gehörige elektrische Ersatzschaltung in der $\Psi$-Ebene ($\Psi = \tanh \frac{pT}{2}$ mit $p = \delta + j\omega$ als komplexer Frequenz, vgl. AEÜ, Band 24, 1970, Seiten 506 bis 512, und Band 25 (1971), Seiten 295 bis 303), wenn dabei zunächst der von der Taktphase 5 gesteuerte Schalter S21 und der zugehörige gestrichelt gezeichnete Anschluss unberücksichtigt bleibt. Die Schaltung von Fig. 9b lässt die Kettenschaltung mehrerer Schaltungsabschnitte erkennen. So ist beispielsweise die Signalquelle, die bereits anhand von Fig. 8 besprochen wurde, mit der Quelle i(t) dem Kondensator $C_Q$ und dem von der Taktphase 6 gesteuerten Schalter S12 erkennbar. Auch ist am Ausgang der Schaltung, der den Abschlusswiderstand nachbildende Kondensator $C_R$ in Verbindung mit dem Schalter S11 gemäss Fig. 7 zugeschaltet. Die inneren Schaltungsabschnitte bestehen aus Querzweigen, deren Wirkungsweise bereits anhand von Fig. 6 besprochen wurde. Lediglich zur Unterscheidung sind die Kondensatoren im Schalternetzwerk mit C5 und C8 bezeichnet. Die Ankopplung erfolgt über Kondensatoren C4 und C7 und aufeinanderfolgende Einzelglieder sind über die Kondensatoren C3, C6 und C9 miteinander verbunden. Charakteristisch für die Schaltung ist nun, dass alle sog. kritischen unabhängigen Schleifen nur über die von den Taktphasen 1 und 2 gesteuerten Spannungsumkehrschalter $S_u$ geschlossen sind. Es sind hier als «unabhängige Schleifen» bzw. als «kritische unabhängige Schleifen» solche Schleifen bezeichnet, bei denen sich infolge der Schaltvorgänge zwischen den Spannungsumkehr- bzw. Umladevorgängen die Summe der Spannungen über den die einzelnen Schaltelemente realisierenden Kondensatoren ändern kann.

Das Ausgangssignal wird im Ausgangszweig über einen von der Taktphase 5 gesteuerten Schalter S15 zur Verfügung gestellt, wobei die Lage der Taktphase unmittelbar wiederum Fig. 4 zu entnehmen ist. Danach muss das Ausgangssignal im Zeitintervall zwischen der zweiten und der sechsten Taktphase zur Verfügung gestellt werden.

Wenn man am Kondensator $C_Q$ entsprechend der gestrichelt gezeichneten Linie in Fig. 9b das reflektierte Signal über den Schalter S21, der von der Taktphase 5 gesteuert ist, abnimmt, dann erhält man die zum Hochpass komplementäre Filterfunktion, nämlich eine Tiefpassfilterfunktion, so dass also Schaltungen nach Fig. 9b auf diese Weise den Charakter von Filterweichen annehmen.

Wie in Fig. 9 zu erkennen ist, liegt der rechts von der gestrichelten Linie gezeichnete, die Ausgangsspannung zur Verfügung stellende Zweig über den Spannungsumkehrschalter $S_u$ auf Bezugspotential 13. Aus diesem Grund ist der eigentliche Filterausgang einseitig nicht geerdet, also nicht mit Bezugspotential zu verbinden. Für Anwendungsfälle, in denen dies nicht erwünscht ist, lässt sich der rechts von der gestrichelten Linie liegende Abschnitt durch eine Schaltung nach Fig. 10 ersetzen.

Es wird hierzu ein zusätzlicher Schalter S13 im Längszweig vorgesehen, der von den bereits besprochenen Taktphasen 3 und 7 gesteuert ist. Weiterhin wird der mit 18 bezeichnete Verbindungspunkt, der zwischen dem Kondensator $C_R$ und dem Spannungsumkehrschalter $S_u$ liegt, über einen weiteren Schalter S14, der von der Taktphase 5 gesteuert ist, auf Bezugspotential 13 gelegt. Auf diese Weise steht das Ausgangssignal über dem von der Taktphase 5 gesteuerten Schalter S15 in geerdeter Form zur Verfügung.

Durch die vorstehenden Grundbausteine wird es auch möglich, weitere für den Entwurf von Filterschaltungen erforderliche Grundschaltelemente zu realisieren. Entsprechende Ausführungsbeispiele sind in den Fig. 11 bis 14 gezeigt.

Die Schaltung von Fig. 11 ist geeignet, eine sog. Einheitsleitung, für die sich auch der Ausdruck «Unit Element» in der Fachsprache eingebürgert hat, zu realisieren. Die Schaltung 19 hat dabei den Charakter eines Zweitornetzwerkes, in dessen Querzweig ein Kondensator $C_E$ und ein Spannungsumkehrschalter $S'_u$ in Serie geschaltet sind. Der Spannungsumkehrschalter $S'_u$ besteht dabei aus den anhand der Fig. 1, 2 und 16 bereits erläuterten Schaltern S1 bis S6, wobei allerdings die Schalter S1, S3 und S5 durch die Taktphasen 1 und 5 gemäss Fig. 4 gesteuert sind, während die Schalter S2, S4 und S6 durch die Taktphasen 2 und 6 gesteuert sind. Es sind also die ungeradzahligen Schalter in der ersten und fünften Taktphase geschlossen, während die geradzahligen Schalter in der zweiten und sechsten Taktphase geschlossen sind. Das elektrische Ersatzschaltbild einer Schaltung 19 von Fig. 11 ist in Fig. 12 dargestellt. Es hat entsprechend dem Charakteristikum der Einheitsleitung für Signale mit Abtastcharakter die Länge T/2 und den Wellenwiderstand $R = T/2C_E$.

Die in Fig. 13 gezeigte Schaltung ermöglicht es, eine sog. gyrierende Einheitsleitung zu realisieren. Die Schaltung 20 hat ebenfalls den Charakter eines Zweitores, in derem Querzweig ein Spannungsumkehrschalter $S_u'$ vorhanden ist, der in seiner Wirkungsweise mit der von Fig. 11 übereinstimmt. In Fig. 13 ist dem Spannungsumkehrschalter $S_u'$ ein Schalternetzwerk 20' vorgeschaltet, das aus vier Schaltern S17 bis S20 besteht, von denen gewissermassen die Schalter S17 und S18 in Serie geschaltet sind, ebenso die Schalter S19 und S20, wobei jeweils zwei der in Serie geschalteten Schalter zueinander parallel liegen. An die Verbindungspunkte zwischen den Schaltern S17 und S18 bzw. den Schalter S19 und S20 ist ein Kondensator $C_G$ geschaltet. Wie Fig. 13 ferner unmittelbar zu entnehmen ist, sind die Schalter S17 und S19 im Rhythmus der Taktphasen 3 und 4 zu schalten, während die Schalter S18 und S20 im Rhythmus der Taktphasen 7 und 8 zu schalten sind. Das elektrische Ersatzschaltbild der Schaltung von Fig. 13 ist in Fig. 14 als gyrierende Einheitsleitung mit der Länge T/2 und dem Gyrationswiderstand $R = T/2C_G$ zu erkennen. Hierzu äquivalent ist ein Ersatzschaltbild, das aus einer nichtgyrierenden Einheitsleitung mit der Länge T/2 und dem Wellenwiderstand $R = T/2C_G$ besteht, dem ein Gyrator mit dem Gyrationswiderstand $R = T/2C_G$ nachgeschaltet ist.

Im Schaltbild von Fig. 13 kann der mit $S_u'$ bezeichnete Schalter auch durch einen Schalter ersetzt werden, der in vorhergehenden Ausführungsbeispielen mit $S_u$ bezeichnet wurde. Man wird von dieser Möglichkeit stets dann Gebrauch machen, wenn dies zum jeweils zu realisierenden Filterverhalten erforderlich ist.

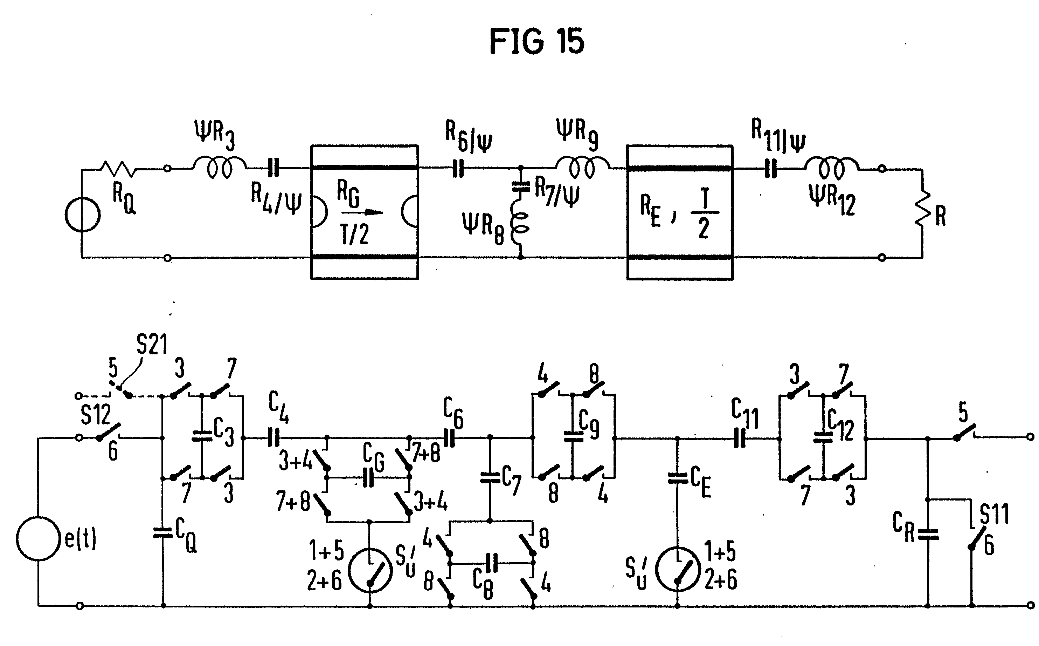

Als mögliches Anwendungsbeispiel ist in Fig. 15 eine Bandpassschaltung achten Grades gezeigt, die jeweils einen doppelten Dämpfungspol für die Frequenzen $\omega = 0$ und $\omega \rightarrow \infty$ liefert. Auch diese Schaltung ist in einer solchen Weise aufgebaut, dass alle kritischen unabhängigen Schleifen nur über Spannungsumkehrschalter, im Ausführungsbeispiel also über die Spannungsumkehrschalter $S_u'$, geschlossen sind. Die einzelnen Schaltungsabschnitte wurden, wie sich aus einem Vergleich mit den vorhergehenden Figuren unmittelbar ergibt, bereits im einzelnen besprochen. In den Längszweigen der Schaltung liegen noch Schaltungsabschnitte, die unmittelbar aus Fig. 6 hervorgehen. Die Kopplung aufeinanderfolgender Längszweige erfolgt jeweils über die Kondensatoren C4, C6 und C11. Im mittleren Querzweig ist über einen Kondensator C7 ebenfalls eine Schaltung gemäss Fig. 6 angekoppelt. Die entsprechende Steuerung über die Taktphasen 1 bis 8 ist unmittelbar an den Schaltern angegeben. Das elektrische Ersatzschaltbild ist in Fig. 15 ebenfalls mitgezeichnet.

Entsprechend zu Fig. 9 hat auch die in Fig. 15 gezeigte Schaltung die Eigenschaft, die komplementäre Filterfunktion zu liefern, wenn am Kondensator $C_Q$, wie gestrichelt eingezeichnet ist, über einen Schalter S21, der von der Taktphase 5 gesteuert wird, die das reflektierte Signal darstellende Spannung abgenommen wird. Im vorliegenden Fall hat also der dem Schalter S21 nachfolgende Ausgang den Charakter einer Bandsperre und es kann von dieser Weicheneigenschaft stets dann Gebrauch gemacht werden, wenn dies im speziellen Anwendungsfall erforderlich ist.

Anhand der Fig. 17 bis 20 wird noch gezeigt, dass sich mit Hilfe der in Fig. 1, 2 und 16 beschriebenen Spannungsumkehrschalter auch Zirkulatoren und damit Allpassschaltungen realisieren lassen.

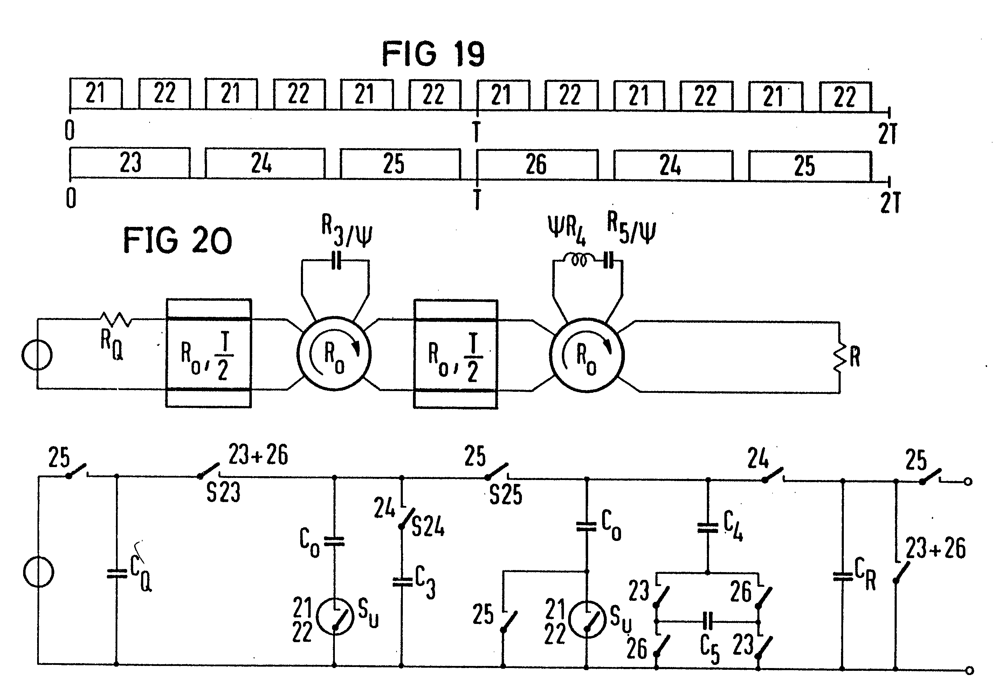

In Fig. 17 ist die mit 30 bezeichnete Schaltung ein Dreitor, bei dem die Leitung 13 auf Bezugspotential liegt, so dass jeweils die Tore 31, 13 bzw. 32, 13 bzw. 33, 13 entstehen. Der Spannungsumkehrschalter $S_u$ mit den Anschlussklemmen 11 und 12 liegt gewissermassen zwischen den Verzweigungspunkten und es ist ihm ein Kondensator $C_Z$ vorgeschaltet. In den zu den Anschlussklemmen führenden Längszweigen 31, 32 und 33 liegen die Schalter S23, S24 und S25, von denen der Schalter S23 mit der Taktphase 23 und 26, der Schalter S24 mit der Taktphase 24 und der Schalter S25 entsprechend mit der Taktphase 25 gesteuert wird. Der Spannungsumkehrschalter $S_u$ selbst wird von den beiden Taktphasen 21 und 22 gesteuert. In Fig. 19 ist der zugehörige Taktplan gezeichnet, und zwar über den Zeitraum 0 bis 2T und es wiederholt sich dieser Taktplan periodisch im Abstand 2T. Wie aus Fig. 19 zu erkennen ist, haben die Taktphasen 23 bis 26 jeweils eine solche Länge, dass sie die Taktphasen 21 und 22 überlappen. Im Zeitraum 0 bis T werden die von den Taktphasen 23, 24, 25 gesteuerten Schalter geschlossen, und im Zeitraum T bis 2T werden die von den Taktphasen 26, 24 und 25 gesteuerten Schalter geschlossen.

Das elektrische Ersatzschaltbild der Schaltung nach Fig. 17 ist in Fig. 18 gezeichnet, wobei zu erkennen ist, dass der Zirkulator den Widerstand $R = T/2C_Z$ darstellt. An den Toren 31, 13 bzw. 32, 13 bzw. 33, 13 treten die Spannungen $U_1$ bzw. $U_2$ bzw. $U_3$ auf, und es fliessen in diese Tore jeweils die Ströme $I_1$ bzw. $I_2$ bzw. $I_3$, wobei dem Tor 31, 13 ein Einheitselement mit dem Wellenwiderstand R und der Leitungslänge T/2 folgt. Es hat also auch die in Fig. 17 gezeigte Schaltung die Eigenschaft, dass elektrische Signale, die an einem beliebigen Tor eingespeist werden, jeweils nur am nächstfolgenden Tor abgegeben werden.

Im Beispiel von Fig. 20 ist noch eine Allpassschaltung gezeigt, die wiederum aus der Kettenschaltung an sich bereits besprochener Schaltungsabschnitte besteht, und die wiederum Spannungsumkehrschalter $S_u$ und einfache Schalter enthält. In den Längszweigen der Schaltung liegen wiederum Schalter, deren Schliessungsdauer von den Taktphasen 23 bis 26 bestimmt werden. Im ersten Querzweig liegt ein Spannungsumkehrschalter $S_u$, dem der Kondensator $C_o$ vorgeschaltet ist. Parallel hierzu liegt ein einfacher Schalter S24, gesteuert von der Taktphase 24, dem in Serie ein Kondensator C3 nachgeschaltet ist. Im darauffolgenden Querzweig ist ebenfalls ein weiterer Spannungsumkehrschalter $S_u$ zu erkennen, parallel dazu liegt jedoch ein einfacher Schalter, der von der Taktphase 25 gesteuert ist. Schliesslich liegt in einem weiteren Querzweig ein über dem Kondensator C4 angekoppeltes Netzwerk, dessen Wirkungsweise dem Prinzip nach bereits anhand von Fig. 6 beschrieben wurde. Die Eingangs- und Ausgangsnetzwerke sind anhand der Fig. 7 und 8 erläutert. Zu beachten ist lediglich, dass für die Schaltung von Fig. 20 der in Fig. 19 dargestellte Taktplan eingehalten wird.

Das in Fig. 20 gezeichnete elektrische Ersatzschaltbild wurde in seinen wesentlichen Teilen ebenfalls bereits erläutert. Am ersten Zirkulator entspricht der mit $R_3$ bezeichnete Kondensator dem über den Schalter S24 gesteuerten Kondensator C3 und es entspricht am zweiten Zirkulator die mit $R_4$ bzw. $R_5$ bezeichnete Serienschaltung aus Spule und Kapazität dem über den Kondensator C4 angekoppelten Schalternetzwerk in Verbindung mit der Kapazität C5.

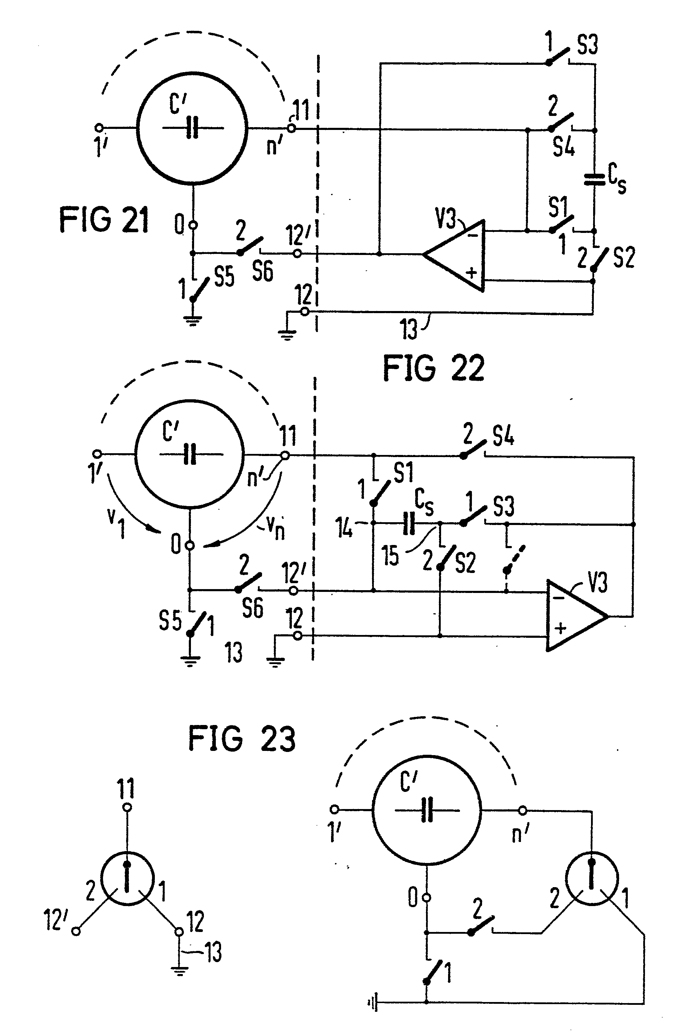

In der Schaltung von Fig. 16 ist zu erkennen, dass dort der Operationsverstärker V3 stets dann vom Bezugspotential 13 weggeschaltet wird, wenn der mit der Taktphase 1 gesteuerte Schalter S1 öffnet. Wenn es darauf ankommt – was beispielsweise dann der Fall sein kann, wenn parasitäre Erdkapazitäten stören – den Verstärker stets einseitig auf Erdpotential zu halten, dann lässt sich dies durch Einführung weiterer Schalter erreichen, die während aufeinanderfolgender Taktphasen 1 und 2 abwechselnd geschlossen sind. Mögliche Ausgestaltungen solcher Schalter sind in den Fig. 21 und 22 dargestellt, in denen die rechts von der gestrichelten Linie gezeichnete Schaltung wiederum als invertierende Wiederaufladungsschaltung bezeichnet sei. Wie dort zu erkennen ist, sind die einzelnen Schalter ebenfalls von Taktphasen 1 und 2, die wiederum unmittelbar an die Schalter angeschrieben sind, gesteuert. Es muss dabei dafür gesorgt werden, dass auch hier die Taktphasen sich nicht überlappen, so dass also korrespondierende Schaltergruppen (z.B. Taktphase 2) stets erst dann schliessen, wenn die Schalter der anderen Gruppe (z.B. Taktphase 1) bereits geöffnet sind. Auch in diesen beiden Schaltungen ist wiederum der als Zwischenspeicher wirkende Kondensator $C_s$ zu erkennen, der entweder unmittelbar (Fig. 22) an den invertierenden Eingang des Operationsverstärkers V3 führt oder es wird der invertierende Eingang über den von der Taktphase 1 gesteuerten Schalter (Fig. 21) erreicht. In jedem Fall liegt der nichtinvertierende Eingang des Verstärkers V3 auf Bezugspotential 13.

Für die Schaltungen nach den Fig. 21 und 22 lässt sich ganz allgemein ein Schaltsymbol angeben, wie dies in Fig. 23 gezeigt ist. Daraus ist zu erkennen, dass die in den Fig. 21 und 22 gezeichneten Schalter als dreipolige Schalter wirken, von denen beispielsweise in der Taktphase 1 stets Erdpotential angelegt werden kann, während in der Taktphase 2 weitere Kapazitätsnetzwerke ganz allgemeiner Art, in Fig. 23 symbolisch durch C' bezeichnet, angeschaltet werden können. Schalter nach den Fig. 21 und 23 lassen sich auch in entsprechenden Schaltungsarten der im vorstehenden beschriebenen Beispiele anwenden, wobei allerdings zu beachten ist, dass gegebenenfalls die Zuordnung der Schaltertaktphasen für die invertierenden Wiederaufladungsschalter zu den Taktphasen, von denen die übrigen Grundbausteine der jeweiligen Filterschaltung gesteuert werden, so erfolgt, dass die anhand der beschriebenen Ausführungsbeispiele gewünschten Funktionen auch dann erfüllt werden, wenn Schalter nach den Fig. 21 bis 23 zum Einsatz kommen.

Bei Verwendung mehrerer Spannungsumkehrschalter nach dem Wiederaufladungsprinzip gemäss Fig. 21 bis 23 in einem Gesamtfilter ist der Wiederaufladevorgang in mehreren Taktphasen, jeweils den einzelnen Schaltern zugeordnet, sequentiell durch die Einführung zusätzlicher Taktphasen vorzunehmen.

Für die vorstehenden Ausführungsbeispiele sei noch auf folgendes hingewiesen.

Der Erfindung zugrunde liegende Untersuchungen haben gezeigt, dass die in den einleitend genannten Literaturstellen angegebenen Resonanz-Transfer-Filter so modifiziert werden können, dass sie für heute zur Verfügung stehende technologische Mittel brauchbar werden. Die wesentlichen Schaltelemente, die nötig sind, wurden vorstehend Spannungsumkehrschalter genannt. Ein Spannungsumkehrschalter kann verhältnismässig einfach mit Hilfe von Operationsverstärkern und gewöhnlichen Schaltern gebaut werden. Im folgenden sollen noch die grundlegenden Prinzipien dieser Schalterkapazitätsfilter mit Spannungsumkehrschaltern dargelegt werden.

Die angegebene Methode eröffnet eine Reihe einfacher Möglichkeiten, verlustfreie Abzweigschaltungen, die zwischen ohmschen Abschlusswiderständen betrieben werden, nachzubilden. Die entsprechenden Filter erfreuen sich somit der ausgezeichneten Eigenschaften hinsichtlich der Dämpfungsmöglichkeit, die Filter solcher Strukturen haben. Die Entwurfstheorie enthält keine Annahmen hinsichtlich der Abtast-(Arbeits-)Rate, d.h. die Abtastrate kann so niedrig sein, wie es mit dem Nyquist-Theorem vereinbar ist. Übertragungs-Nullstellen (Dämpfungspole) können an beliebigen Frequenzstellen in den Sperrbereich gelegt werden. Diese Eigenschaften zusammen mit der Tatsache, dass nur Kapazitätsverhältnisse von Bedeutung sind, dass die Zahl der kritischen, elektronischen Elemente (beispielsweise Operationsverstärker) wesentlich niedriger ist als für andere Entwurfsmethoden und dass weiterhin die gesamte Schaltungsanordnung verhältnismässig einfach ist, machen die hier beschriebenen Filter auch für den Aufbau in integrierter Technologie durchaus zugänglich. Bei der praktischen Realisierung ist es möglich, die Spannungsumkehrschalter stets einseitig an Bezugspotential, z.B. Erdpotential, zu legen.

Für die geerdeten Spannungsumkehrschalter gilt folgendes. Es sei ein $(n'+1')$-Netzwerk von z.B. Fig. 22 betrachtet, von dem vorausgesetzt ist, dass es ausschliesslich aus Kapazitäten (zusammenfassend mit C' bezeichnet) besteht. Seine Klemmen sind mit den laufenden Nummern $v = 0,1',...., n'$, bezeichnet, die Bezugsklemme ist $v = 0$, die Klemmen $2'$ bis $n'-1$ sind gestrichelt angedeutet. Es sei angenommen, dass in einem vorgegebenen Zeitpunkt Ladungen auf den Kapazitäten vorhanden sind; die resultierenden Werte der Spannungen $v_v$ sollen mit $v_{vb}$ (b = vorher = before) bezeichnet werden. In jede Klemme $v, v = 1'$ bis $n'$, wird eine Ladung $q_v$ geschickt, die daraus resultierenden neuen Werte der Spannungen $v_v$ sollen mit $v_{va}$ (a = nachher = after) bezeichnet werden. Insbesondere ist man interessiert, folgendes zu erhalten

$$v_{va} = -v_{vb}, \qquad v = 1' \text{ bis } n'. \tag{1}$$

Anordnungen, die diese Bedingungen erfüllen, sind als Spannungsumkehrschalter bezeichnet.

Eine verhältnismässig einfache, rasche Methode zur Realisierung eines geerdeten Spannungsumkehrschalters ist in Fig. 1 gezeigt. Es werden dabei zwei Operationsverstärker V1, V2 verwendet, die als Spannungsfolger geschaltet sind. Während eines ersten Zeitintervalls sind die mit 1 bezeichneten Schalter geschlossen, während die mit 2 bezeichneten Schalter offen sind. Die Spannung $v_s$ über der Speicherkapazität $C_s$ wird dann gleich der Spannung an der Klemme 11 bezüglich Erdpotential, d.h. Klemme 12. Nachdem die Schalter 1 wieder geöffnet sind, werden die Schalter 2 geschlossen. Demzufolge ist die Spannung, die dann zwischen den Klemmen 11 und 12 erscheint, die negative Spannung gegenüber der ursprünglich zwischen diesen Klemmen vorhandenen Spannung.

Es ist wesentlich, dass zwischen den Zeitintervallen, in denen die Schalter 1 und 2 jeweils geschlossen sind, keinerlei Überlappung auftritt, d.h. die Schalter 1 sind offen, ehe die Schalter 2 sich zu schliessen beginnen und umgekehrt. Daraus folgt insbesondere, dass die beiden Operationsverstärker in der Schaltung von Fig. 1 nie gleichzeitig aktiv sind. Demzufolge kann der Spannungsumkehreffekt auch mit einer Schaltung nach Fig. 2 erreicht werden, die nur einen Operationsverstärker benötigt und bei der die Schalter in der eben besprochenen Weise arbeiten.

Die Schaltungen nach den Fig. 1 und 2 sind nicht die einzigen Beispiele zur Realisierung von geerdeten Spannungsumkehrschaltern. Insbesondere ist es nicht nötig, stets alle Details darzustellen und man kann demzufolge einen Spannungsumkehrschalter durch das in Fig. 3 gezeichnete Symbol darstellen (die Erdverbindung ist kenntlich gemacht und die Zahlen 1 und 2 haben dieselbe Bedeutung wie in Fig. 1 und 2). Es wird festgelegt, dass der Schalter arbeitet, wenn er den Prozess der Spannungsumkehr ausführt. Die Arbeitsperiode erstreckt sich somit von dem Zeitpunkt, von dem die Schalter 1 sich zu schliessen beginnen bis zu dem Zeitpunkt, an dem die Schalter 2 völlig offen sind. Weitere Kapazitätsnetzwerke mit mehreren Klemmen, bei denen Spannungsumkehrschalter gleichzeitig arbeiten, sind vorstehend für weitere Beispiele gezeigt.

Der mit Resonanz-Transfer-Schaltungen vertraute Leser erkennt daraus, dass ein Spannungsumkehrschalter den gleichen Gesamteffekt wie ein Resonanz-Transfer-Schalter bewirkt. Es können daher die Schaltungen nach den Fig. 1 und 2 als elektronische Realisierungen eines geerdeten Resonanz-Transfer-Schalters aufgefasst werden.

Im einzelnen haben die angegebenen Schaltungen folgende Eigenschaften.

Die vorliegenden Schaltungen können durch geeignete Interpretation als Schaltungen betrachtet werden, in denen als Abtastproben vorliegende Signale verarbeitet werden. Ein wesentlicher Punkt in der vorliegenden Theorie ist darin zu sehen, für diese Schaltungen geeignete äquivalente Schaltungen zu finden, die für sich bekannt sind. Um diese zu erreichen, muss zuerst eine passende Frequenz festgelegt werden.

Es sei F die Arbeitsrate der betrachteten Schaltung, T die entsprechende Arbeitsperiode, d.h.

$$F = 1/T, \qquad \Omega = 2\pi F = 2\pi/T \qquad (2)$$

und p die komplexe Frequenz des Signals. Eine passende äquivalente komplexe Frequenz ist dann die Grösse $\Psi$, die definiert ist durch

$$\Psi = \tanh(pT/2) = (z-1)/(z+1), \ z = e^{pT} \qquad (3)$$

die auch früher beispielsweise für Resonanz-Transfer-Schalter in den einleitend genannten Literaturstellen zugrunde gelegt wurde.

Die Vorteile der Transformation (2) sind bekannt. Es sei daran erinnert, dass folgende Beziehungen gelten

$$\begin{aligned}
\text{Re } p &> 0 <===> \text{Re}\Psi > 0 \\
\text{Re } p &= 0 <===> \text{Re}\Psi = 0 \qquad (4) \\
\text{Re } p &< 0 <===> \text{Re}\Psi < 0,
\end{aligned}$$

dass für $p = j\omega$ sich ergibt

$$\Psi = j\varphi, \qquad \varphi = \tan(\omega T/2), \qquad (5)$$

und dass das Nyquist-Intervall $0 < \omega < \Omega/2$ (wobei $\Omega$ durch (2) definiert ist) in den Gesamtbereich $0 < \varphi < \infty$ transformiert wird. Eine wichtige Folgerung, die aus (4) gezogen werden kann, ist, dass Stabilität in der $\Psi$-Ebene die Stabilität in der p-Ebene gewährleistet.

Man hat sich im folgenden mit Impulsströmen auseinanderzusetzen, d.h. mit Strömen $i = i(t)$, die aus einer Pulsfolge bestehen. Von den einzelnen Impulsen muss vorausgesetzt werden, dass sie während periodisch sich wiederholenden Intervallen auftreten, aber es brauchen keine Annahmen hinsichtlich der Pulsbreite gemacht werden, mit Ausnahme davon, dass sich die Impulse nicht überlappen dürfen; vor allem braucht die Pulsbreite in keinem Fall kurz im Verhältnis zu T zu sein.

Der n-te Puls soll auf einen Zeitpunkt $t_n$ fallen und innerhalb der Pulsbreite liegen und sei durch

$$t_n = t_0 + nT, \qquad n = \ldots -1,0,1,2,\ldots, \qquad (6)$$

gegeben, wobei $t_0$ eine Konstante (Fig. 4) ist. Die gesamte Ladung, die durch den n-ten Puls transportiert wird, sei mit $q(t_n)$ bezeichnet.

Es sei darauf hingewiesen, dass für die folgenden Erläuterungen es durchaus ausreichend wäre, $t_0 = 0$ zu wählen, die Ergebnisse werden jedoch nicht berührt werden, wenn $t_0 \neq 0$ ist.

Für die grundlegenden Elemente gelten folgende Überlegungen. Es sei eine Kapazität C betrachtet, in die der Pulsstrom $i = i(t)$ fliesst und der von der vorstehend diskutierten Form ist. Dabei sei $v = v(t)$ die Spannung über dieser Kapazität C.

Insbesonders ist man interessiert an den Spannungen $v_b$ und $v_a$, die als die Werte von v gerade vor Pulsbeginn und gerade nach Pulsende definiert werden. Es werden diese Spannungen bezogen auf den Zeitpunkt $t_n$, der dem jeweils betrachteten Impuls entspricht. Demzufolge kann genauer $v_b = v_b(t_n)$ und $v_a = v_a(t_0)$ geschrieben werden. Die Gleichungen

$$v_a(t_n) - v_b(t_n) = q(t_n)/C \qquad (7)$$

und

$$v_b(t_{n+1}) = v_a(t_n) \qquad (8)$$

sind offensichtlich gültig. Es wird ferner eine Spannung $u = u(t_n)$ folgendermassen definiert

$$u(t_n) = [v_a(t_n) + v_b(t_n)]/2 \qquad (9)$$

Um die Differenzengleichungen (7) bis (9) unter Bedingungen des eingeschwungenen Zustandes auszudrücken, lässt sich schreiben

$$v_a(t_n) = v_a e^{pt_n}, \quad v_b(t_n) = V_b e^{pt_n} \qquad (10)$$

$$u(t_n) = U e^{pt_n}, \quad q(t_n) = Q e^{pt_n} \qquad (11)$$

wobei $V_a$, $V_b$, U und Q komplexe Konstante sind. Benutzt man Gleichung (3) und die Gleichungen (6) bis (9) und eliminiert $V_a$ und $V_b$, dann erhält man schliesslich

$$U = JR/\Psi \qquad (12)$$

wobei J und R durch

$$J = Q/T, \quad R = T/2C \qquad (13)$$

definiert sind.

Wenn man somit U als äquivalente Spannung und I als äquivalenten Strom auffasst, kann Gleichung (12) als Spannungs-Strom-Abhängigkeit einer Kapazität mit der Impedanz $R/\Psi$ aufgefasst werden, d.h. die Gleichung (12) entspricht der äquivalenten Schaltung einer Kapazität. Zu beachten ist, dass noch folgende Beziehung gilt

$$U = (V_a + V_b)/2, \quad RJ = (V_a - V_b)/2 \qquad (14)$$

$$V_a = U + RJ, \quad V_b = U - RJ \qquad (15)$$

und dass R als Sprungwiderstand (für den in der englischen Fachsprache der Ausdruck «step resistance» verwendet wird) in der Theorie der bereits erwähnten Resonanz-Transfer-Schaltungen bezeichnet wurde.

Es sei nunmehr der eben besprochene Kondensator C durch Zuschalten eines Klemmenumkehrschalters (vgl. Fig. 6) abgewandelt, der die Klemmen von C zwischen zwei aufeinanderfolgenden Pulsen von i(t) umkehrt. Ein derartiger Inverter ist verhältnismässig einfach durch vier einfache Schalter gem. Fig. 6 zu realisieren. Es reicht dann aus, dass beispielsweise die mit der Taktphase 3 (4) betriebenen Schalter geschlossen und die mit der Taktphase 7 (8) betriebenen Schalter offen sind, während der n-te Impuls ankommt, wenn n ungeradzahlig ist und umgekehrt, wenn n geradzahlig ist. Das Vorhandensein des Klemmenumkehrschalters verändert (7) nicht, aber es wird (8) ersetzt durch $v_b(t_{n+1}) = -v_a(t_n)$.

Benutzt man wiederum (9) bis (11) und (3), (6) und (13), dann erhält man

$$U = J\Psi R. \qquad (16)$$

Dieser Gleichung entspricht die äquivalente Schaltung einer Induktivität mit der Impedanz $\Psi R$, die in der Fig. 6 ebenfalls dargestellt ist.

Die Schaltung von Fig. 7 zeigt eine Kapazität C, die dort zur besseren Übersicht mit $C_R$ bezeichnet ist, in die ein Strom i(t) nach vorstehender Definition fliesst, und einen Hilfsschalter S11, der geöffnet ist, wenn ein Impuls von i(t) ankommt und der aber $C_R$ in jedem Intervall entlädt, das zwei aufeinanderfolgende Impulse trennt. Gleichung (7) bleibt dadurch gültig, jedoch muss Gleichung (8) ersetzt werden durch $v_b(t_n) = 0$.

Benutzt man wiederum (9) bis (11) und (13), so erhält man .

$$U = JR. \qquad (17)$$

Dieser Gleichung entspricht die äquivalente Schaltung eines Widerstandes R (Fig. 7). Ein solcher Widerstand kann in einem Filter als Abschlusswiderstand benützt werden, gegebenenfalls indem ihm beispielsweise ein Spannungsfolger nachgeschaltet wird.

Die Schaltung von Fig. 8 wird von der nach Fig. 7 abgeleitet, indem eine ideale Spannungsquelle $e_o(t)$ in Serie mit dem Schalter S12 geschaltet wird. Dieser Schalter ist wiederum während der Zeit offen, während der ein Puls von i(t) ankommt, ist aber geöffnet in den Impulspausen. Es sei $t_n-T_o$, wobei $T_o$ eine Konstante ist, der Zeitmoment, zu welchem S12 geöffnet ist ehe der zum Zeitpunkt $t_n$ gehörende Impuls ankommt. Es gilt dann die Beziehung $v_b(t_n) = e_o(t_n-T_o)$ was somit die Gleichung ist, durch die (8) ersetzt werden muss, während (7) gleich bleibt. Benutzt man wiederum (9) bis (11) und (13) und $e_o(t_n) = E_o e^{pt_n}$, dann erhält man

$$U = E + JR, \quad E_o e^{-pT_o} \qquad (18)$$

Dieser Gleichung entspricht die äquivalente Schaltung einer Spannungsquelle E in Serie mit einem Widerstand $R_i$ (Fig. 8). Der Unterschied zwischen E und $E_o$ ist zu vernachlässigen, da er lediglich einer einheitlichen Verzögerung $T_o$ entspricht.

Um eine Spannungsquelle zu erhalten, deren Innenwiderstand nahezu den Wert Null hat, ist es in der Praxis möglich, von einem Spannungsfolger Gebrauch zu machen, der zwischen S12 und $e_o(t)$ geschaltet ist.

Es ist zu beachten, dass (14) und (15) gültig bleiben für alle vier Schaltungsanordnungen, die gerade besprochen wurden. Die äquivalenten Schaltungen, zu denen man gelangt, können auch zur Berechnung der durchschnittlich übertragenen Leistung P herangezogen werden. Unter der Annahme, dass $p = j\omega$ ist, lässt sich schreiben $U = /U/e^{j\alpha}, Q/J/e^{j\beta}$.

Nimmt man den Realteil der entsprechenden komplexen Grössen, dann erhält man

$$u(t_n) = /U/\cos(\omega t_n + \alpha), \quad q(t_n) = T/J/\cos(\omega t_n + \beta). \qquad (19)$$

Anderseits ist die von einem Puls übertragene Energie

$$[v^2_a(t_n) - v^2_b(t_n)]C/2 = u(t_n)q(t_n) \qquad (20)$$

wobei von den Gleichungen (7) und (9) Gebrauch gemacht wurde, d.h. von Zusammenhängen, die in allen Fällen gültig sind. Vergleicht man (19) und (20) und verwendet (6), dann ist zu ersehen, indem man das zeitliche Mittel von (20) nimmt, dass

$$P = ReUJ^*/2 = ReU^*J/2, \qquad (21)$$

unter der Voraussetzung gilt, dass $\omega$ nicht ein Vielfaches von $\Omega/2$ ist (vgl. (2)).

Da Gleichung (21) exakt für konventionelle Schaltungen gilt, geht daraus hervor, dass alle anderen klassischen Ergebnisse, die von diesen Beziehungen abgeleitet sind, ebenfalls Gültigkeit haben. Beispielsweise ist die mittlere Leistung, die von einem Widerstand R (Fig. 7) aufgenommen wird, gegeben durch $/J/^2R/2$ und die maximale Leistung, die einer Quelle gemäss Fig. 8 entnommen werden kann, ist $/E/^2/8R_i = /E_o/^2/8R_i$.

Die vorstehenden Überlegungen lassen sich in entsprechender Anwendung der an sich aus den genannten Literaturstellen bekannten theoretischen Zusammenhänge auch der Realisierung der weiterhin besprochenen Schaltungen zu Grunde legen, die lediglich als Beispiele für eine Vielzahl möglicher Realisierungsstrukturen anzusehen sind.

**Patentansprüche**

1. Spannungsumkehrschalter, der derart ausgebildet ist, dass die Spannung (V) an den Schalterklemmen (11, 12) nach Betätigung des Schalters dem Betrage nach gleich gross, jedoch entgegengesetzt gerichtet ist zur Spannung (V) vor Betätigung des Schalters, bestehend aus Schaltern und von diesen in mehreren Taktphasen geschalteten Kondensatoren und Verstärkern, insbesondere zur Verwendung in aktiven Filtern für elektrische Schwingungen, dadurch gekennzeichnet, dass die an den Schalterklemmen (11, 12) anliegende Spannung in einer ersten Taktphase (1) über einen ersten Verstärker (V1) auf einem Kondensator ($C_S$) zwischengespeichert wird und in einer zweiten Taktphase (2) über einen zweiten Verstärker (V2) diese Spannung in invertierter Form den Schalterklemmen (11, 12) wieder aufgeprägt wird (Fig. 1, 3, 4).

2. Spannungsumkehrschalter nach Anspruch 1, dadurch gekennzeichnet, dass eine Klemme (12) an einer durchgehenden, auf Bezugspotential liegenden Leitung (13) angeschaltet ist, dass von der zweiten Klemme (11) ein erster Schalter (S1), der von einer ersten Taktphase (1) gesteuert ist, an den Eingang eines ersten Verstärkers (1) mit der Verstärkung +1 angelegt ist und über einen zweiten Schalter (S2), der mit einer zweiten Taktphase (2) gesteuert ist, an den Ausgang eines zweiten Verstärkers (V2) mit der Verstärkung +1 gelegt ist, dass vom Ausgang des ersten Verstärkers (V1) ein dritter Schalter (S3), gesteuert von der ersten Taktphase (1), an einen ersten Schaltungsknoten (14) führt, von dem aus einerseits ein vierter Schalter (S4), gesteuert von der zweiten Taktphase (2), an die auf Bezugspotential liegende Leitung (13) und anderseits ein Kondensator ($C_s$) zu einem zweiten Schaltungsknoten (15) führt, der über einen fünften Schalter (S5), gesteuert von der ersten Taktphase (1), mit Bezugspotential (13) verbunden ist und über einen sechsten Schalter (S6), gesteuert von der zweiten Taktphase (2), mit dem Eingang des zweiten Verstärkers (V2) verbunden ist (Fig. 1, 3, 4).

3. Spannungsumkehrschalter nach Anspruch 1 oder 2, dadurch gekennzeichnet, dass für die zweite Taktphase (2) anstelle des zweiten Verstärkers (V2) der erste Verstärker (V1) benutzt ist, derart, dass der zweite Schalter (S2) von der zweiten Klemme (11) zum Ausgang des ersten Verstärkers (V1) anstelle des zweiten Verstärkers (V2) führt, und dass der sechste Schalter (S6) vom zweiten Schaltungsknoten (15) zum Eingang des ersten Verstärkers (V1) anstelle des zweiten Verstärkers (V2) führt (Fig. 2, 3, 4).

4. Spannungsumkehrschalter, der derart ausgebildet ist, dass die Spannung (V) an den Schalterklemmen (11, 12) nach Betätigung des Schalters dem Betrage nach gleich gross, jedoch entgegengesetzt gerichtet ist zur Spannung (V) vor Betätigung des Schalters, bestehend aus Schaltern und von diesen in mehreren Taktphasen geschalteten Kondensatoren und Verstärkern, insbesondere zur Verwendung in aktiven Filtern für elektrische Schwingungen, dadurch gekennzeichnet, dass in einer ersten Taktphase (1) die Schalterklemmen (11, 12) auf gleiches Potential gebracht werden und die dabei über diese Klemmen fliessende Ladung in einem Kondensator ($C_S$) zwischengespeichert wird und dass der Kondensator ($C_S$) anschliessend in einer zweiten Taktphase (2) entladen wird und diese Ladung in gleicher Richtung wie in der ersten Taktphase über die Schalterklemmen (11, 12) geführt wird (Fig. 3, 4, 16).

5. Spannungsumkehrschalter nach Anspruch 4, dadurch gekennzeichnet, dass der Verstärker als Operationsverstärker (V3) ausgebildet ist, von dessen nichtinvertierendem Eingang (21) der erste Schalter (S1), gesteuert von der ersten Taktphase (1) zu der auf Bezugspotential (13) liegenden Klemme (11) führt, und dass der zweite Schalter (S2), gesteuert von der zweiten Taktphase (2), von der ersten Klemme (11) zum nichtinvertierenden Eingang (21) des Operationsverstärkers (V3) anstelle des Ausgangs des Verstärkers (V1) führt, und dass vom zweiten Schaltungsknoten (15) der fünfte Schalter (S5), gesteuert von der ersten Taktphase (1), zum Ausgang des Operationsverstärkers (V3) anstelle Bezugspotential (13) führt, und dass vom ersten Schaltungsknoten (14) der dritte Schalter (S3), gesteuert von der ersten Taktphase (1), zur ersten Klemme (11) anstelle zum Ausgang des Verstärkers (V1) führt, und dass der vierte Schalter (S4), gesteuert von der zweiten Taktphase (2), zum Ausgang des Operationsverstärkers (V3) anstelle Bezugspotential (13) führt, und dass weiterhin der erste Schaltungsknoten (14) mit dem invertierenden Eingang des Operationsverstärkers (V3) verbunden ist (Fig. 3, 4, 16).

6. Spannungsumkehrschalter nach einem der Ansprüche 1 bis 5, dadurch gekennzeichnet, dass zur Realisierung einer Induktivität ein Kondensator (C) über ein aus vier Schaltern (S7, S8, S9, S10) bestehendes Schalternetzwerk, gesteuert von einer dritten und einer siebten (3, 7) oder von einer vierten und einer achten (4, 8) Taktphase, mit einem Klemmenpaar (16, 17) verbunden ist, derart, dass die beiden mit der dritten oder vierten Taktphase (3 oder 4) gesteuerten Schalter (S7, S9) und die beiden anderen von der siebten oder achten Taktphase (7 oder 8) gesteuerten Schalter (S8, S10) den Kondensator (C) periodisch umpolen (Fig. 4, 6).

7. Spannungsumkehrschalter nach einem der Ansprüche 1 bis 5, dadurch gekennzeichnet, dass zur Realisierung eines Widerstandes (R) einem Kondensator ($C_R$) ein elfter Schalter (S11) parallel geschaltet ist, der von einer sechsten Taktphase (6) gesteuert ist, derart, dass dieser Schalter (S11) jeweils zwischen den Spannungsumkehr- bzw. Umladevorgängen des in dieser kritischen Schleife liegenden Spannungsumkehrschalters ($S_u$ bzw. $S'_u$) geschlossen ist (Fig. 4, 7).

8. Spannungsumkehrschalter nach einem der Ansprüche 1 bis 5, dadurch gekennzeichnet, dass zur Realisierung einer Signalquelle (E) mit Innenwiderstand ($R_i$) eine als Spannungsquelle ($e_o(t)$) wirkende Signalquelle über einen zwölften Schalter (S12) an einen Kondensator ($C_Q$) angeschaltet ist und von einer sechsten Taktphase (6) dieser Schalter (S12) derart gesteuert ist, dass er nur im Zeitintervall zwischen der zweiten (2) und der ersten Taktphase (1) geschlossen ist (Fig. 4, 8).

9. Filter unter Verwendung von Spannungsumkehrschaltern nach einem der vorhergehenden Ansprüche, dadurch gekennzeichnet, dass bei Zusammenschaltung mehrerer Schaltungsabschnitte alle kritischen unabhängigen Schleifen nur über Spannungsumkehrschalter ($S_u$) geschlossen sind und dass das Ausgangssignal über einen Schalter (S15) während einer fünften Taktphase (5) zur Verfügung steht, derart, dass dieser Schalter (S15) jeweils zwischen den Spannungsumkehr- bzw. Umladevorgängen des in dieser kritischen Schleife liegenden Spannungsumkehrschalters ($S_u$ bzw. $S'_u$) geschlossen ist (Fig. 4, 9).

10. Filter nach Anspruch 9, dadurch gekennzeichnet, dass ein die Ausgangsspannung zur Verfügung stellender Zweig ($C_R$, S11), der über einen Spannungsumkehrschalter ($S_u$) mit Bezugspotential (13) verbunden ist, über einen dreizehnten Schalter (S13) mit dem vorgeschalteten Schaltungsabschnitt verbunden ist, und dass dieser Schalter (S13) von der dritten und der siebten Taktphase (3, 7) gesteuert ist und dass der Verbindungspunkt (18) zwischen dem die Ausgangsspannung zur Verfügung stellenden Zweig ($C_R$, S11) und dem Spannungsumkehrschalter ($S_u$) über einen vierzehnten Schalter (S14) während der fünften Taktphase (5) auf Bezugspotential (13) gelegt ist und die Ausgangsspannung über den fünfzehnten Schalter (S15) während der fünften Taktphase (5) zur Verfügung steht (Fig. 4, 107).

11. Einheitsleitung (Unit Element) unter Verwendung von Spannungsumkehrschaltern nach einem der Ansprüche 1 bis 5, gekennzeichnet durch die Serienschaltung eines Kondensators ($C_E$) und eines Spannungsumkehrschalters ($S'_u$) im Querzweig eines Vierpols (19) mit zwei durchgehenden Leitungen, von denen eine auf Bezugspotential (13) liegt, und der Spannungsumkehrschalter ($S'_u$) die sechs Schalter (S1 bis S6) enthält und der erste, dritte und fünfte Schalter (S1, S3, S5) während der ersten und fünften Taktphase (1, 5) geschlossen sind und der zweite, vierte und sechste Schalter (S2, S4, S6) während der zweiten und sechsten Taktphase (2, 6) geschlossen sind und dass alle kritischen unabhängigen Schleifen nur über Spannungsumkehrschalter ($S_u$) bzw. ($S'_u$) geschlossen sind (Fig. 4, 11, 12, 15).

12. Einheitsleitung nach Anspruch 11, dadurch gekennzeichnet, dass zur Realisierung einer gyrierenden Einheitsleitung (unit gyroelement) im Vierpol (20) anstelle des Kondensators ($C_E$) eine aus einem Kondensator ($C_G$) und vier Schaltern ($S_{17}$, $S_{18}$, $S_{19}$, $S_{20}$) bestehende Schaltung (20') liegt und diese Schalter (S17 bis S20) über vorgebbare Taktphasen (3, 4 bzw. 7, 8) derart geschaltet sind, dass die gesamte Schaltung (20') einen periodisch betätigten Umpolschalter (periodically reversed switch) bildet (Fig. 4, 13, 14).

13. Filter nach Anspruch 9, 10, dadurch gekennzeichnet, dass über einen einundzwanzigsten Schalter (S21) während der fünften Taktphase (5) die das reflektierte Signal darstellende, am Kondensator ($C_Q$) anliegende Spannung abnehmbar ist (Fig. 9, 15).

14. Zirkulator unter Verwendung von Spannungsumkehrschaltern nach einem der Ansprüche 1 bis 5, dadurch gekennzeichnet, dass ein Dreitor (30) mit einer auf Bezugspotential liegenden Leitung (13) und mit einem Querzweig, der aus der Serienschaltung eines Kondensators ($C_Z$) und eines Spannungsumkehrschalters ($S_u$) besteht, der während einer ersten Taktphase (21) und einer zweiten Taktphase (22) betätigt wird und über einen ersten Schalter (S23), der während einer dritten und einer sechsten Taktphase (23, 26) geschlossen ist, mit dem ersten Tor (31, 13) verbunden ist, über einen zweiten Schalter (S24), der während einer vierten Taktphase (24) geschlossen ist, mit dem zweiten Tor (32, 13) verbunden ist, und über einen dritten Schalter (S25), der während der fünften Taktphase (25) geschlossen ist, mit dem dritten Tor (33, 13) verbunden ist, derart, dass von diesen drei Schaltern (S23, S24, S25) jeweils höchstens einer geschlossen ist und dass alle kritischen und unabhängigen Schleifen nur über Spannungsumkehrschalter ($S_u$ bzw. $S'_u$) geschlossen sind (Fig. 17, 18, 19, 20).

15. Filter nach einem der Ansprüche 9 oder 10, dadurch gekennzeichnet, dass es wenigstens einen als dreipoligen Schalter wirkenden, von zwei unterschiedlichen Taktphasen (1, 2) gesteuerten Schaltungsabschnitt enthält, der derart ausgebildet ist, dass der Verstärker als Operationsverstärker (V3) ausgebildet ist, dessen nichtinvertierender Eingang (+) auf Bezugspotential (13) liegt, dessen invertierender Eingang mit einer dritten Schalterklemme (12') und mit einem Schaltungsknoten (14) verbunden ist, von dem aus der Kondensator ($C_S$) zum Schaltungsknoten (15) führt, dass dieser Schaltungsknoten (15) über einen Schalter (S2), gesteuert von der zweiten Taktphase (2), an Bezugspotential (13) angeschaltet ist und über einen Schalter (S3), gesteuert von der Taktphase (1), der Ausgang des Operationsverstärkers (V3) erreicht wird, von dem aus der vierte Schalter (S4), gesteuert von der Taktphase (2), zur ersten Klemme (11) führt, an die über einen Schalter (S1) gesteuert von der Taktphase (1) die dritte Schalterklemme (12') angeschaltet ist, von der aus ein Schalter (S6), gesteuert von der zweiten Taktphase (2), zum Bezugsknoten (0) des die äussere Beschaltung bildenden Kapazitätsnetzwerkes (C') führt, der über den fünften Schalter (S5), gesteuert von der ersten Taktphase (1), mit Bezugspotential (13) verbunden ist (Fig. 4, 21, 22, 23).

**Claims**

1. A voltage-inverting switching circuit designed in such a manner that after actuation of the switching circuit the voltage (V) at switch terminals (11, 12) has the same value as, but is inverted with respect to the voltage (V) before the actuation of the switching circuit, and which consists of switches, capacitors and amplifiers, switched by said switches in a plurality of clock pulse phases, in particular for use in active filters for electric oscillations, characterised in that the voltage applied to the switch terminals (11, 12) is temporarily stored in a capacitor ($C_S$) via a first amplifier (V1) in a first clock pulse phase, and in a second clock pulse phase (2), the voltage is impressed onto the switch terminals (11, 12) in an inverted form via a second amplifier (V2)(Figs. 1, 3, 4).

2. A voltage-inverting switching circuit as claimed in Claim 1, characterised in that a terminal (12) is connected to a continuous line (13) connected to reference potential, that from the second terminal (11) a first switching circuit (S1) controlled by a first clock pulse phase (1) is connected to the input of a first amplifier (1) having the amplification +1, and via a second switching circuit (S2) controlled by a second clock pulse phase (2) to the output of a second amplifier (V2) having the amplification +1, that from the output of the first amplifier (V1) a third switching circuit (S3) controlled by the first clock pulse phase (1) leads to a first circuit node (14), from which on the one hand a fourth switching circuit (S4), which is controlled by the second clock pulse phase (2), leads to the line (13) connected to reference potential and on the other hand a capacitor ($C_S$) leads to a second circuit node (15) which is connected via a fifth switching circuit (S5) controlled by the first clock pulse phase (1) to the reference potential (13), and which is connected via a sixth switching circuit (S6) controlled by the second clock pulse phase (2) to the input of the second amplifier (V2) (Figs. 1, 3, 4).

3. A voltage-inverting switching circuit as claimed in Claim 1 or 2, characterised in that the first amplifier (V1) is used in place of the second amplifier (V2) for the second clock pulse phase (2) in such a manner that the second switching circuit (S2) leads from the second terminal (11) to the output of the first amplifier (V1) instead of the second amplifier (V2), and that the sixth switching circuit (S6) leads from the second circuit node (15) to the input of the first amplifier (V1) in place of the second amplifier (V2) (Figs. 2, 3, 4).

4. A voltage-inverting switching circuit so constructed that after the actuation of the switching circuit the voltage (V) at the switch terminals (11, 12) has the same value as the voltage (V) before the actuation of the switching circuit, but is oppositely directed, and which consists of switches and of capacitors and amplifiers, which are switched by said switching circuits in a plurality of clock pulse phases, in particular for use in active filters for electric oscillations, characterised in that in a first clock pulse phase (1) the switch terminals (11, 12) are brought onto the same potential and the charge flowing across these terminals is temporarily stored in a capacitor ($C_S$), and that the capacitor ($C_S$) is subsequently discharged in a second clock pulse phase (2) and this charge is fed across the switch terminals (11, 12) in the same direction as in the first clock pulse phase (Figs. 3, 4, 16).

5. A voltage-inverter switching circuit as claimed in Claim 4, characterised in that the amplifier is designed as an operational amplifier (V3), from whose non-inverting input (21) the first switching circuit (S1), which is controlled by the first clock pulse phase (1), leads to the terminal (11) connected to the reference potential (13), and that the second switching circuit (S2), which is controlled by the second clock pulse phase (2), leads from the first terminal (11) to the non-inverting input (21) of the operational amplifier (V3) in place of the output of the amplifier (V1), and that the fifth switching circuit (S5), controlled by the first clock pulse phase (1), leads from the second circuit node (15) to the output of the operational amplifier (V3) instead of the reference potential (13), and that the third switching circuit (S3), which is controlled by the first clock pulse phase (1), leads from the first circuit node (14) to the first terminal (11) instead of the output of the amplifier (V1), and that the fourth switching circuit (S4), controlled by the second clock pulse phase (2) leads to the output of the operational amplifier (V3) in place of the reference potential (13), and that furthermore the first circuit node (14) is connected to the inverting input of the operational amplifier (V3) (Figs. 3, 4, 16).

6. A voltage-inverting switching circuit as claimed in one of Claims 1 to 5, characterised in that in order to realise an inductance, by means of a switch network which consists of four switches (S7, S8, S9, S10) and which is controlled by a third and a seventh (3, 7) or by a fourth and an eigth (4, 8) clock pulse phase, a capacitor (C) is connected to a terminal pair (16, 17) in such a manner that the two switching circuits (S7, S9) controlled by the third or fourth clock pulse phase (3 or 4), and the two other switching circuits (S8, S10) controlled by the seventh or eighth clock pulse phase (7 or 8), periodically change the polarity of the capacitor (C) (Figs. 4, 6).

7. A voltage-inverting switching circuit as claimed in one of Claims 1 to 5, characterised in that in order to produce a resistance (R) a capacitor ($C_R$) is connected parallel to an eleventh switching circuit (S11) controlled by a sixth clock pulse phase (6) in such a manner that this switching circuit (S11) is closed between the voltage-inverting or re-charging operations, as the case may be, of the voltage-inverting switching circuit ($S_u$ or $S'_u$) arranged in this critical loop (Fig. 4, 7).

8. A voltage-inverting switching circuit as claimed in one of Claims 1 to 5, characterised in that in order to realise a signal source (E) having an internal resistance ($R_i$) a signal source acting as a voltage source ($e_o(t)$) is connected to a capacitor ($C_Q$) via a twelfth switching circuit (S12) and the twelfth switching circuit (S12) is controlled by a sixth clock pulse phase (6) in such a manner that it is only closed in the time interval between the second (2) and the first clock pulse phase (1) (Figs. 4, 8).

9. A filter employing voltage-inverting switching circuits as claimed in any one of the preceding Claims, characterised in that when interconnecting a plurality of circuit sections all critically independent loops are only closed via voltage-inverting switching circuits ($S_u$), and that during a fifth clock pulse phase (5) the output signal is available via a switching circuit (S15) in such a manner that this switching circuit (S15) is closed between the voltage-inverting or recharging processes of the voltage-inverting switching circuit ($S_u$ or $S'_u$) which is arranged in this critical loop (Figs. 4, 9).

10. A filter as claimed in Claim 9, characterised in that a branch ($C_R$, S11), which makes available the output voltage and which is connected via a voltage-inverting switching circuit ($S'_u$) to the reference potential (13), is connected to the preceding circuit section by means of a thirteenth switching circuit (S13), and that this switching circuit (S13) is controlled by the third and the seventh clock pulse phase (3, 7), and that the junction point (18) between the branch (C_R, S11), which makes the output voltage available, and the voltage-inverting switching circuit (S_u) is connected to the reference potential (13) via a fourteenth switching circuit (S14) during the fifth clock pulse phase (5), and the output voltage is available via the fifteenth switching circuit (S15) during the fifth clock pulse phase (5) (Figs. 4, 10).

11. A unitary element employing voltage-inverting switching circuits as claimed in one of Claims 1 to 5, characterised by the series connection of a capacitor (C_E) and a voltage-inverting switching circuit (S'_u) in the transverse branch of a four-pole (19) having two continuous lines, one of which is connected to the reference potential (13), and the voltage-inverting switching circuit (S'_u) includes the six switching circuits (S1 to S6) and the first, third and fifth switching circuits (S1, S3, S5) are closed during the first and fifth clock pulse phase (1,5) and the second, fourth and sixth switching circuits (S2, S4, S6) are closed during the second and sixth clock pulse phase (2, 6), and that all critically independent loops are only closed via voltage-inverting switching circuits (S_u) or (S'_u) (Figs. 4, 11, 12, 15).

12. A unit element as claimed in Claim 11, characterised in that in order to realise a gyrating unit element a circuit (20') consisting of a capacitor (C_G) and four switching circuits (S_{17}, S_{18}, S_{19}, S_{20}) is arranged in the four-pole (20) in place of the capacitor (C_E) and these switching circuits (S17 to S20) are switched by predeterminable clock pulse phases (3, 4 and 7, 8) in such a manner that the entire circuit (20') forms a periodically reversed switch (Figs. 4, 13, 14).

13. A filter as claimed in Claim 9, 10 characterised in that during the fifth clock pulse phase (5) the voltage which is connected to the capacitor (C_Q) and which represents the reflected signal can be tapped by means of a twenty-first switching circuit (S21) (Figs. 9, 15).

14. A circulator employing voltage-inverting switching circuits as claimed in one of Claims 1 to 5, characterised in that a three-port circuit (30) is connected to a line (13) applied to the reference potential, and is connected to a transversal branch consisting of the series connection of a capacitor (C_Z) and a voltage-inverting switching circuit (S_u) operated during a first clock pulse phase (21) and a second clock pulse phase (22), and which three-port is connected to the first gate (31, 13) via a first switching circuit (S23) operated during a third and a sixth clock pulse phase (23, 26), and is connected to the second gate (32, 13) via a second switching circuit (24) closed during a fourth clock pulse phase (24), and to the third gate (33, 13) via a third switching circuit (S25) closed during the fifth clock pulse phase (25), in such a manner that at the maximum one of these three switching circuits (S23, S24, S25) is closed, and that all critical and independent loops are only closed via voltage-inverting switching circuits (S_u and S'_u) (Figs. 17, 18, 19, 20).

15. A filter as claimed in one of Claims 9 or 10, characterised in that it comprises at least one circuit section which operates as a three-pole switch and is controlled by two different clock pulse phases (1, 2) and which is constructed in such a manner that the amplifier is designed as an operational amplifier (V3), whose non-inverting input (+) is connected to the reference potential (13), whose inverting input is connected to a third switch terminal (12') and to a circuit node (14), from which the capacitor (C_S) leads to the circuit node (15), that this circuit node (15) is connected to the reference potential by means of a switching circuit (S2) controlled by the second clock pulse phase (2), and via a switching circuit (S3) controlled by the clock pulse phase (1) the output of the operational amplifier (V3) is reached, from which the fourth switching circuit (S4) controlled by the clock pulse phase (2) leads to the first terminal (11), to which by means of a switching circuit (S1) controlled by the clock pulse phase (1) the third switch terminal (12') is connected, from which a switching circuit (S6) controlled by the second clock pulse phase (2) leads to the reference node (0) of the capacitor network (C'), which forms the outer circuit which reference node is connected to the reference potential (13) by means of the fifth switching circuit (S5) controlled by the first clock pulse phase (1) (Figs. 4, 21, 22, 23).

**Revendications**

1. Commutateur inverseur de tension, qui est réalisé de telle façon que la tension (V) aux bornes (11, 12) du commutateur est, après l'actionnement du commutateur, de valeur égale mais de sens opposé à la tension (V) avant l'actionnement du commutateur, constitué par des interrupteurs et par des condensateurs et amplificateurs branchés en plusieurs phases de cadence ces derniers, en particulier pour sa mise en œuvre dans des filtres actifs pour des oscillations électriques, caractérisé par le fait que la tension appliquée aux bornes (11, 12) du commutateur est, dans une première phase de cadence (1), emmagasinée temporairement, par l'intermédiaire d'un premier amplificateur (V1), dans un condensateur (C_S) et que dans une seconde phase de cadence (2) et par l'intermédiaire d'un second amplificateur (V2), cette tension est à nouveau appliquée, sous forme inversée, aux bornes (11, 12) du commutateur.

2. Commutateur inverseur de tension selon la revendication 1, caractérisé par le fait qu'une borne (12) est reliée à un conducteur (13) continu et au potentiel de référence, à partir de la seconde borne (11), un premier interrupteur (S1) qui est commandé par une première phase de cadence (1), est relié à l'entrée d'un premier amplificateur (1) d'amplification + 1, et par l'intermédiaire d'un second interrupteur (S2) qui est commandé avec une seconde phase de cadence (2), à la sortie d'un second amplificateur (V2) à amplification + 1, qu'à partir de la sortie du premier amplificateur (V1), un troisième interrupteur (F3) qui est commandé par la première phase de cadence (1), mène à un premier nœud de circuit (14) à partir duquel, d'une part, un quatrième interrupteur (S4) qui est commandé par la seconde phase de cadence (2) mène au conducteur (13) qui est au potentiel de référence et, d'autre part, un condensateur ($C_S$) mène à un second nœud de circuit (15) qui est relié, par l'intermédiaire d'un cinquième interrupteur (S5) qui est commandé par la première phase de cadence (1), au potentiel de référence (13) et est relié, par l'intermédiaire d'un sixième interrupteur (S6) commandé par la seconde phase de cadence (2), à l'entrée du second amplificateur (V2) (figs 1, 3, 4).

3. Commutateur inverseur de tension selon la revendication 1 ou 2, caractérisé par le fait que pour la seconde phase de cadence (2) on utilise, à la place du second amplificateur (V2), le premier amplificateur (V1), que le second interrupteur (S2) mène de la seconde borne (11) à la sortie du premier amplificateur (V1) à la place du second amplificateur (V2), et que le sixième interrupteur (S6) mène au second nœud de circuit (15) à l'entrée du premier amplificateur (V1) à la place du second amplificateur (V2) (figs 2, 3, 4).

4. Commutateur inverseur de tension qui est réalisé de telle façon que la tension (V) aux bornes (11, 12) du commutateur est, après l'actionnement du commutateur de valeur égale mais dirigé en sens opposé à la tension (V) avant l'actionnement du commutateur, du type constitué par des interrupteurs et par des condensateurs et amplificateurs branchés en plusieurs phases de cadence par lesdits interrupteurs, plus particulièrement pour sa mise en œuvre dans des filtres actifs pour des oscillations électriques, caractérisé par le fait que dans une première phase de cadence (1) les bornes (11, 12) du commutateur sont amenées à un même potentiel, les charges qui passent par ces bornes étant emmagasinées temporairement dans un condensateur ($C_S$), et que le condensateur ($C_S$) est ensuite déchargé dans une seconde phase de cadence (2), cette charge étant amenée à passer, dans la même direction que dans la première phase de cadence, par les bornes (11, 12) du commutateur (figs 3, 4, 16).

5. Commutateur inverseur de tension selon la revendication 4, caractérisé par le fait que l'amplificateur est réalisé sous la forme d'un amplificateur opérationnel (V3) à partir de l'entrée non inverseuse (21) duquel, le premier interrupteur (S1), commandé par la première phase de cadence (1) mène à la borne (11) qui est au potentiel de référence (13) et que le second interrupteur (S2), commandé par la seconde phase de cadence (2) mène de la première borne (11) à l'entrée non inverseuse (21) de l'amplificateur opérationnel (V3), à la place de la sortie de l'amplificateur (V1), et qu'à partir du second nœud de circuit (15), le cinquième interrupteur (S5), commandé par la première phase de cadence (1), mène à la sortie de l'amplificateur opérationnel (V3) à la place du potentiel de référence, et qu'à partir du premier nœud de circuit (14), le troisième interrupteur (S3), commandé par la première phase de cadence (1), mène à la première borne (11) à la place de la sortie de l'amplificateur (V1), et que le quatrième interrupteur (S4), commandé par la seconde phase de cadence (2), mène à la sortie de l'amplificateur opérationnel (V3), à la place du potentiel de référence (13) et qu'en outre le premier nœud de circuit (14) est relié à l'entrée inverseuse de l'amplificateur opérationnel (V3) (figs 3, 4, 16).

6. Commutateur inverseur de tension selon l'une des revendications 1 à 5, caractérisé par le fait que pour réaliser une inductance, un condensateur (C) est relié, par l'intermédiaire d'un réseau de commutation qui est constitué par quatre interrupteurs (S7, S8, S9, S10), commandé par une troisième et une septième (3, 7) ou par une quatrième et une huitième (4, 8) phases de cadence, à une paire de bornes (16, 17), la réalisation étant telle que les deux interrupteurs (S7, S9) qui sont commandés par la troisième ou la quatrième phase de cadence (3 ou 4), et les deux autres interrupteurs (S8, S10) qui sont commandés par la septième ou la huitième phase de cadence (7 ou 8) inversent périodiquement la polarité du condensateur (C) (figs 4, 6).

7. Commutateur inverseur de tension selon l'une des revendications 1 à 5, caractérisé par le fait que pour réaliser une résistance (R), on branche en parallèle sur un condensateur ($C_R$) un onzième interrupteur (S11) qui est commandé par une sixième phase de cadence (6), la réalisation étant telle que cet interrupteur (S11) est fermé respectivement entre les opérations d'inversion de tension ou d'inversion de charge du commutateur inverseur de tension ($S_u$ et $S'_u$) qui se situent dans cette boucle critique (figs 4, 7).

8. Commutateur inverseur de tension selon l'une des revendications 1 à 5, caractérisé par le fait que pour réaliser une source de signaux (E) à résistance interne ($R_i$) on branche une source de signaux agissant comme source de tension ($e_o(t)$), par l'intermédiaire d'un douzième interrupteur (S12), à un condensateur ($C_Q$), ledit interrupteur (S12) étant commandé par une sixième phase de cadence (6) de telle manière qu'il n'est fermé que pendant l'intervalle de temps se situant entre la seconde (2) et la première (1) phases de cadence (figs 4, 8).

9. Filtre, avec mise en œuvre de commutateurs inverseurs de tension selon l'une des revendications précédentes, caractérisé par le fait que lors du branchement de plusieurs sections de circuit, toutes les boucles critiques et indépendantes ne sont fermées que par l'intermédiaire de commutateurs inverseurs de tension ($S_u$), et que le signal de sortie est disponible pendant une cinquième phase de cadence (5) par l'intermédiaire d'un interrupteur (S15), la réalisation étant telle que cet interrupteur (S15) n'est fermé que respectivement entre les opérations d'inversion de tension ou d'opérations d'inversion de charge du commutateur inverseur de tension ($S_u$ et $S'_u$) qui se situent dans cette boucle critique (figs 4, 9).

10. Filtre selon la revendication 9, caractérisé par le fait qu'une branche ($C_R$, S11) qui met à la disposition la tension de sortie et qui est reliée par l'intermédiaire d'un commutateur inverseur de tension ($S_u$) au potentiel de référence, est reliée, par l'intermédiaire d'un treizième interrupteur (S13) à la section de circuit amont, et que cet interrupteur (S13) est commandé par la troisième et par la septième phases de cadence (3, 7), et que le point de liaison (18) entre la branche ($C_R$, S11) qui met à la disposition la tension de sortie, et le commutateur inverseur de tension ($S_u$), est relié, par l'intermédiaire d'un quatorzième interrupteur (S14), pendant la cinquième phase de cadence (5), au potentiel de référence (13), alors que la tension de sortie est disponible pendant la cinquième phase de cadence (5), par l'intermédiaire du quinzième interrupteur (S15)(figs 4, 107).

11. Circuit unitaire (Unit Element) avec mise en œuvre de commutateurs inverseurs de tension selon l'une des revendications 1 à 5, caractérisé par le montage série d'un condensateur ($C_E$) et d'un commutateur inverseur de tension ($S'_u$) dans la branche transversale d'un quadripôle (19) à deux conducteurs continus dont l'un est au potentiel de référence (13) et le commutateur inverseur de tension ($S'_u$) comporte les six interrupteurs (S1 à S6) et le premier, le troisième et le cinquième interrupteurs (S1, S3, S5) sont fermés pendant la première et la cinquième phases de cadence (1, 5) et le second, le quatrième et le sixième interrupteurs (S2, S4, S6) sont fermés pendant la seconde et la sixième phases de cadence (2, 6), et que toutes les boucles critiques indépendantes ne sont fermées que par l'intermédiaire de commutateurs inverseurs de tension ($S_u$) et ($S'_u$) (figs 4, 11, 12, 15).

12. Circuit unitaire selon la revendication 11, caractérisé par le fait que pour réaliser un circuit unitaire rotatoire (unit gyroelement), on prévoit dans le quadripôle (20), à la place du condensateur ($C_E$), un montage (20') constitué par un condensateur ($C_G$) et par quatre interrupteurs ($S_{17}$, $S_{18}$, $S_{19}$, $S_{20}$), lesdits interrupteurs (S17 à S20) étant branchés, par l'intermédiaire de phases de cadence prédéterminées (3, 4 ou 7, 8) de manière que la totalité du montage (20') constitue un commutateur d'inversion de polarité (periodically reversed switsch), commandé périodiquement (figs 4, 13, 14).

13. Filtre selon la revendication 9, 10, caractérisé par le fait que par l'intermédiaire d'un vingt-et-unième interrupteur (S21) on peut prélever, pendant la cinquième phase de cadence (5) la tension qui se présente au niveau du condensateur ($C_Q$) et représentant le signal réfléchi (figs 9, 15).

14. Circulateur avec mise en œuvre de commutateurs inverseurs de tension selon l'une des revendications 1 à 5, caractérisé par le fait qu'un dispositif à trois entrées (30), avec un conducteur (13) qui est au potentiel de référence et avec une branche transversale qui est constituée par un circuit série d'un condensateur ($C_Z$) et d'un commutateur inverseur de tension ($S_u$) qui est commandé pendant une première phase de cadence (21) et une seconde phase de cadence (22) et qui est fermé, par l'intermédiaire d'un premier interrupteur (S23), pendant une troisième et une sixième phases de cadence (23, 26), est relié avec la première entrée (31, 13), et qui est, par l'intermédiaire d'un second interrupteur (S24) qui est fermé pendant une quatrième phase de cadence (25), relié avec la seconde entrée (32, 13), et qui est relié, par l'intermédiaire d'un troisième interrupteur (S25) fermé pendant la cinquième phase de cadence (25), à la troisième entrée (33, 13), la réalisation étant telle que parmi ces trois interrupteurs (S23, S24, S25) au moins l'un d'eux est fermé, et que toutes les boucles critiques et indépendantes ne sont fermées que par l'intermédiaire du commutateur inverseur de tension ($S_u$, $S'_u$) (figs 17, 18, 19, 20).

15. Filtre selon l'une des revendications 9 ou 10, caractérisé par le fait qu'il comporte au moins une section de circuit agissant comme commutateur tripolaire et commandée par deux phases de cadence différentes (1, 2), laquelle section de circuit est réalisée de telle façon que l'amplificateur est constitué par un amplificateur opérationnel (V3) dont l'entrée non inverseuse (+) est au potentiel de référence, dont l'entrée inverseuse est reliée à une troisième borne (12') du commutateur et à un nœud de circuit (14) à partir duquel le condensateur ($C_S$) mène au nœud de circuit (15), que ce nœud de circuit (15) est relié, par l'intermédiaire d'un interrupteur (S2) commandé par la seconde phase de cadence (2), au potentiel de référence (13) et, par l'intermédiaire d'un interrupteur (S3) commandé par la phase de cadence (1), est relié à la sortie de l'amplificateur opérationnel (V3) à partir de laquelle le quatrième interrupteur (S4) commandé par la phase de cadence (2), conduit à la première borne (11) à laquelle est reliée, par l'intermédiaire d'un interrupteur (S1) commandé par la phase de cadence (1), la troisième borne de commutateur (12') à partir de laquelle un interrupteur (S6) commandé par la seconde phase de cadence (2), mène au nœud de référence (0) du réseau capacitif (C') qui constitue le circuit extérieur, lequel réseau est relié, par l'intermédiaire du cinquième interrupteur (S5) commandé par la première phase de cadence (1), au potentiel de référence (13)(figs 4, 21, 22, 23).

# FIG 1

# FIG 2

# FIG 3

# FIG 5

FIG 4

$t_0$  $t_0+T$  $t_0+2T$  $t_0+3T$  $t_0+4T$

1
2
5
6
3
4
7
8

# FIG 6

# FIG 7

# FIG 8

21

FIG 9

**FIG 10**

$$C_R$$

3+7
S13

5
S15

6
S11

18

$\frac{1}{2}$  $S_U$

5
S14

13

**FIG 11**

$C_E$

19

$S'_U$  $\frac{1+5}{2+6}$

13

**FIG 12**

19    T/2    $R = T/2C_E$

**FIG 13**

$\underline{20'}$

3+4
S17

7+8
S20

$C_G$

7+8
S18

S19
3+4

20

$S'_U$  $\frac{1+5}{2+6}$

13

**FIG 14**

$R = \frac{T}{2C_G}$

20    T/2

III

$R = \frac{T}{2C_G}$

20    T/2

$R = \frac{T}{2C_G}$

25

FIG 15

FIG 16

FIG 17

FIG 18

$R = T/2C_Z$

# FIG 19

# FIG 20

0 020 379

FIG 21

FIG 22

FIG 23

33